# EUROPEAN PATENT APPLICATION

(11) **EP 4 209 339 A1**
(43) Date of publication of application: **12.07.2023**
(21) Application number: 21871434.3
(22) Date of filing: 18.09.2021
(51) Int. Cl.: B32B 5/00, B32B 1/00, B60R 13/08, G10K 11/16

(54) **HOUSING, VIBRATION ASSEMBLY, AND VEHICLE**

(30) Priority: 23.09.2020 CN 202011007910; 04.12.2020 CN 202011407556
(71) Applicant: Huawei Technologies Co., Ltd., Shenzhen, Guangdong 518129 (CN)
(72) Inventor: WANG, Xiuwei, Shenzhen, Guangdong 518129 (CN); WEI, Min, Shenzhen, Guangdong 518129 (CN); TIAN, Fei, Shenzhen, Guangdong 518129 (CN); WANG, Zheng, Shenzhen, Guangdong 518129 (CN); LIU, Chaobin, Shenzhen, Guangdong 518129 (CN)
(74) Representative: Pfenning, Meinig & Partner mbB
(86) International application number: PCT/CN2021/119201
(87) International publication number: WO 2022/063064

(57) **Abstract**

Embodiments of this application disclose a housing, a vibration assembly, and a vehicle including the vibration assembly. The housing includes a polymer layer and a metal layer. The metal layer is located at an innermost layer of the housing. A material used for the metal layer includes a metal material. The polymer layer is located on an outer side of the metal layer. A material used for the polymer layer includes a polymer material. The housing provided in this application can convert mechanical vibration energy into heat energy for dissipation, thereby achieving a noise reduction effect.

## Description

This application claims priority to Chinese Patent Application No. 202011007910.4, filed with the China National Intellectual Property Administration on September 23, 2020 and entitled "HOUSING, VIBRATION ASSEMBLY, AND VEHICLE", and Chinese Patent Application No. 202011407556.4, filed with the China National Intellectual Property Administration on December 4, 2020 and entitled "HOUSING, VIBRATION ASSEMBLY, AND VEHICLE", which are incorporated herein by reference in their entireties.

### TECHNICAL FIELD

This application relates to the field of vehicle technologies, and in particular, to a housing, a vibration assembly, and a vehicle.

### BACKGROUND

With continuous improvement of research and development technologies of vehicles and people's living standards, people have increasingly high requirements on performance of reducing noise, vibration, and harshness (noise, vibration, and harshness, NVH) of vehicles. When a vehicle is running, a motor in the vehicle generates noise due to vibration. The noise is radiated out of the motor through a housing of the motor, affecting noise reduction performance of the entire vehicle.

### SUMMARY

This application provides a housing, a vibration assembly, and a vehicle. The housing provided in this application can convert mechanical energy that generates vibration into heat energy for dissipation, thereby achieving a noise reduction effect.

According to a first aspect, this application provides a housing. The housing includes a polymer layer and a metal layer. The metal layer is located at an innermost layer of the housing. A material used for the metal layer includes a metal material. The metal material may be but is not limited to steel or aluminum. The polymer layer is located on an outer side of the metal layer. It can be understood that the polymer layer is located on an outer side of the housing, and the metal layer is located on an inner side of the housing. A material used for the polymer layer includes a polymer material.

A damping coefficient of the polymer layer is greater than that of the metal layer. A damping coefficient is a standard for measuring a damping magnitude of a polymer material. A larger damping coefficient indicates better damping performance of the polymer material and a higher ability to dissipate vibration energy. For example, the damping coefficient of the polymer layer may be greater than or equal to 0.05. The polymer material is usually a viscoelastic material such as rubber or asphalt, or may be a plastic material. The plastic material includes general engineering plastic and special engineering plastic. The general engineering plastic mainly includes five types of general engineering plastic, namely, polyamide, polycarbonate, polyformaldehyde, modified polyether, and thermoplastic polyester. The special engineering plastic is mainly engineering plastic with a heat resistance of more than 150°C, and mainly includes polyimide, polyphenylene sulfide, polysulfone, aromatic polyamide, polyarylate, polybenzoate, polyaryletherketone, a liquid crystal polymer, fluorine resin, and the like. For example, the polymer material may alternatively be plastic such as polycarbonate (polycarbonate, PC), polyphenylene sulfide (phenylenesulfide, PPS), ABS plastic (acrylonitrile butadiene styrene plastic, ABS), polyamide 46 (polyamide 46, PA46), or polyamide 66 (polyamide 66, PA66). The polymer layer may include some additives, for example, a glass fiber, a carbon fiber, or an asbestos fiber.

In this embodiment of this application, the polymer layer included in the housing can convert mechanical vibration energy generated by a vibration member into heat energy for dissipation, thereby reducing vibration transferred by the vibration assembly to the outer side of the housing, and helping reduce noise generated by the vibration assembly. When the polymer layer of the housing is made of a plastic material, vibration of the housing can be effectively reduced, costs of the housing can also be effectively reduced, thereby facilitating large-scale production of the housing. In addition, the metal layer in the housing can shield an electromagnetic signal to improve an electromagnetic shield capability of the vibration assembly. In addition, the metal layer is located on the inner side of the housing. The metal layer located on the inner side of the housing can be in direct contact with a bottom housing of a vibration member, thereby achieving a grounding purpose and simplifying an electromagnetic shield design of the housing.

In this embodiment of this application, an example in which the housing includes the polymer layer and the metal layer is used for description. In some other embodiments, when the polymer layer uses conductive plastic, the housing may not include the metal layer, that is, the housing includes only the polymer layer using the conductive plastic. The conductive plastic is a functional high polymer material obtained by mixing resin with a conductive substance and processing the mixture in a processing manner for plastic. In this embodiment, when the polymer layer uses the conductive plastic, the housing can also have an electromagnetic shield capability. In this case, no additional shield layer needs to be arranged in the housing, thereby simplifying a molding process of the housing and facilitating assembling of the housing.

In some embodiments, a cavity exists between the polymer layer and the metal layer.

In this embodiment of this application, the cavity is formed between the polymer layer and the metal layer. In this way, a direct contact area between the polymer layer and the metal layer is reduced, and vibration transferring is reduced. In addition, the cavity effectively absorbs low-frequency noise generated by the vibration member, thereby further reducing noise generated by the vibration assembly.

In some embodiments, the polymer layer includes a first main body portion and a first edge portion arranged around a circumferential edge of the first main body portion. The first main body portion and the metal layer are spaced apart from each other; and the first edge portion is fixedly connected to the metal layer, so that the cavity is formed between the metal layer and the polymer layer.

In some embodiments, the housing is applied to an enclosure of a vibration member in a vehicle. The vibration member is provided with a first vibration region and a second vibration region. When the vibration assembly is in a working state, vibration of the first vibration region is greater than vibration of the second vibration region. It can be understood that vibration of the first vibration region is greater than vibration of the second vibration region. In this case, noise generated in the first vibration region is greater than that generated in the second vibration region. For example, a magnitude of the vibration of each region of the vibration member is determined by detecting the noise in each region of the vibration member. Specifically, a frequency corresponding to a point with large noise is determined, and a modal formation of the housing corresponding to the frequency is determined. For example, when the modal formation of the housing is a first-order modal, an intermediate region of the housing has maximum vibration, and the first vibration region is located in the intermediate region of the housing. An orthographic projection of the first main body portion on the vibration member covers the first vibration region.

In this embodiment of this application, the orthographic projection of the first main body portion on the vibration member covers the first vibration region, that is, an orthographic projection of the cavity formed between the polymer layer and the metal layer on the vibration member covers the first vibration region. The cavity can effectively dissipate noise generated by the vibration member, thereby effectively reducing noise generated by the vibration assembly.

In some embodiments, the metal layer includes a second main body portion and a second edge portion arranged around a circumferential edge of the second main body portion. The second main body portion is recessed relative to the second edge portion towards one side away from the first main body portion. The second edge portion is fixedly connected to the polymer layer.

In this embodiment of this application, the second main body portion of the metal layer is recessed relative to the second edge portion, that is, an intermediate portion of the metal layer is recessed inwards. The polymer layer is fixedly connected to an edge of the metal layer, so that the cavity is formed between the metal layer and the polymer layer. In other embodiments, the polymer layer may alternatively protrude relative to the metal layer, so that a cavity is formed between the polymer layer and the metal layer

In some embodiments, the metal layer and the polymer layer are connected through mutual fastening. For example, the metal layer is provided with a bulge protruding towards the polymer layer. The polymer layer is provided with a groove adapted to the bulge. The bulge is fastened with the groove. The metal layer may be integrally formed into a bulge in a stamping manner.

In this embodiment of this application, the metal layer is positioned and fixedly connected to the polymer layer through fastening to facilitate assembling of the metal layer and the polymer layer. In other embodiments, the metal layer and the polymer layer may alternatively be connected by using glue or by riveting protruding points. This is not limited in this application.

In some embodiments, the housing further includes a fastener. A first fastening hole is formed on an edge of the polymer layer, and a second fastening hole is formed on an edge of the metal layer. The fastener passes through the first fastening hole and the second fastening hole to fasten the polymer layer and the metal layer.

In this embodiment of this application, the polymer layer and the metal layer are fixedly connected by using the fastener to improve firmness of the connection between the polymer layer and the metal layer. Optionally, a metal sheet is embedded in the first fastening hole of the polymer layer to avoid a risk that the fastener is not securely fastened when passing through the second fastening hole of the metal layer, thereby further improving firmness of the housing.

In some embodiments, the polymer layer and the metal layer are integrally formed. For example, the metal layer and the polymer layer are integrally formed by using an intra-film injection molding process to simplify a molding process of the housing. The metal layer may be provided with a hole. This is not limited in this application. For example, the metal layer may alternatively be a metal mesh, so that a weight of the housing is reduced while electromagnetic compatibility protection of the vibration assembly is improved. In some other embodiments, the metal layer may be formed on the polymer layer by using an electroplating process. This is not limited in this application.

In some embodiments, a thickness of the polymer layer is greater than or equal to that of the metal layer. For example, the thickness of the polymer layer is greater than or equal to 1 mm.

In this embodiment of this application, the thickness of the polymer layer is greater than that of the metal layer. The polymer layer can alternatively be relatively thick on the basis of ensuring that the housing is relatively thin. Therefore, mechanical vibration of the housing can be effectively dissipated to reduce noise.

According to a second aspect, this application further provides a housing. The housing includes a metal layer and a polymer layer embedded in the metal layer. The metal layer is provided with one or more grooves. The polymer layer is accommodated in the grooves. A material used for the metal layer includes a metal material, and a material used for the polymer layer includes a polymer material.

In this embodiment of this application, the polymer layer in the housing is embedded in the metal layer, and the polymer layer can effectively dissipate mechanical vibration generated by a vibration member, thereby reducing noise. In addition, the polymer layer is embedded in the metal layer, so that a thickness of the housing is effectively reduced on the basis of ensuring that the housing has vibration attenuation, noise reduction and signal shield functions.

In some embodiments, an air layer is formed between the polymer layer and the metal layer

In this embodiment of this application, the air layer is formed between the polymer layer and the metal layer. In this way, a direct contact area between the polymer layer and the metal layer is reduced, and vibration transferring is reduced. In addition, the cavity effectively absorbs low-frequency noise generated by the vibration member, thereby further reducing noise generated by the vibration assembly.

According to a third aspect, this application further provides a vibration assembly. The vibration assembly is applied to a vehicle. The vibration assembly includes a vibration member and the housing described above. The housing is located on an outer side of the vibration member. When the vibration assembly is in a working state, the vibration member vibrates and generates noise.

In some embodiments, the vibration assembly is a powertrain, a charging apparatus, a power distribution box, a self-driving hardware platform, a battery management system, or an intelligent cockpit. In this embodiment of this application, an example in which the vibration assembly is a powertrain is used for description.

According to a fourth aspect, this application further provides a housing. The housing is an enclosure of a vibration assembly. The housing includes an outer layer, an intermediate layer, and an inner layer. The outer layer is located on an appearance side of the housing; the inner layer is arranged opposite to the outer layer; and the intermediate layer is located between the outer layer and the inner layer. It can be understood that the outer layer is an outermost layer of the housing, and the inner layer is an innermost layer of the housing. At least one of the intermediate layer and the inner layer includes a polymer material. For example, the polymer material may be a viscoelastic material such as rubber or asphalt, or may be a plastic material. The plastic material may be but is not limited to general engineering plastic and special engineering plastic.

In some embodiments, a material used for the intermediate layer includes a polymer material. For example, a damping coefficient of the intermediate layer is greater than or equal to 0.05. A damping coefficient is a standard for measuring a damping magnitude of a polymer material. A larger damping coefficient indicates better damping performance of the polymer material and a higher ability to dissipate vibration energy.

In this embodiment of this application, the polymer material used in the intermediate layer of the housing can effectively convert mechanical vibration energy generated by a vibration member into heat energy for dissipation, thereby reducing vibration transferred by the vibration assembly to the outside, and helping reduce noise generated by the vibration assembly. When the intermediate layer of the housing is made of a plastic material, vibration of the housing can be effectively reduced. Furthermore, because costs of the plastic material are relatively low, costs of the housing can be effectively reduced, thereby facilitating large-scale production of the housing.

In some other embodiments, a material used for the inner layer includes a polymer material. It can be understood that in this embodiment of this application, at least one of the intermediate layer and the outer layer includes the polymer material to reduce a vibration magnitude of the housing and reduce noise.

When the material used for the inner layer includes the polymer material, the material used for the intermediate layer of the housing may be the polymer material, or may be another material. This is not limited in this application. When the material used for the intermediate layer includes the polymer material, the material used for the inner layer of the housing may be the polymer material, or may be another material, for example, a metal material. This is not limited in this application.

In this embodiment of this application, when one of the inner layer and the intermediate layer uses the polymer material, and the other one uses a metal material, the housing has relatively high structural strength and is not easy to fall. This helps improve long-term reliability of the housing. When the materials used for the inner layer and the intermediate layer both include the polymer material, the polymer material is relatively thick, and more mechanical vibration energy can be converted into heat energy for dissipation, thereby helping further improve the noise reduction performance of the housing.

In some embodiments, a material used for the outer layer includes a metal material to improve electromagnetic compatibility (electromagnetic compatibility, EMC) protection. The metal material may be but is not limited to steel or aluminum. In this embodiment of this application, the outer layer may be used as a metal shield layer to avoid an electromagnetic signal generated by the vibration member from interfering with an electronic element outside the vibration assembly, and also avoid an electromagnetic signal generated by an electronic element outside the vibration assembly from interfering with the vibration member inside the vibration assembly. For example, in this embodiment of this application, an example in which the material used for the outer layer includes the metal material, the material used for the intermediate layer includes the polymer material, and the material used for the inner layer includes the metal material is used for description.

It can be understood that shielding is to perform metal isolation between two space regions to control induction and radiation of an electric field, a magnetic field, and electromagnetic waves from one region to another region. Specifically, interference sources of components, circuits, assemblies, cables, or an entire system are wrapped by using shield bodies to prevent an interference electromagnetic field from spreading. A receiving circuit, a device, or a system is wrapped by using a shield body to prevent the receiving circuit, the device, or the system from being affected by an external electromagnetic field.

In some embodiments, when the material used for the intermediate layer includes a polymer material, a thickness of the intermediate layer is greater than or equal to that of the outer layer. The thickness of the intermediate layer is greater than or equal to that of the inner layer. In some embodiments, a thickness of the intermediate layer is greater than or equal to 1 mm. For example, the thickness of the intermediate layer is 2 mm, the thickness of the outer layer is 0.5 mm, and the thickness of the inner layer is 0.5 mm.

In this embodiment of this application, the thickness of the intermediate layer using the polymer material is greater than that of the outer layer using the metal material. The polymer layer can alternatively be relatively thick on the basis of ensuring that the housing is relatively thin. Therefore, mechanical vibration of the housing can be effectively dissipated to reduce noise. For example, when a total thickness of the housing is 3 mm, the thickness of the intermediate layer can be greater than or equal to 1 mm to ensure the thickness of the polymer layer.

In some embodiments, the inner layer is provided with a plurality of micro via holes that are formed at intervals. The micro via holes only run through the inner layer and do not extend to the intermediate layer. For example, an aperture of each micro via hole is less than or equal to 1 mm.

In this embodiment of this application, the inner layer is provided with the plurality of micro via holes that are formed at intervals. Many run-through small gaps are formed in the inner layer. Sound waves (noise) generated by the vibration member change with expansion and retraction of air when entering the micro via holes, and vibrate on hole walls of the micro via holes to generate friction. Due to effects of viscous damping and friction for heat generation of the inner layer itself, sound energy is continuously converted into heat energy and dissipated, thereby reducing the noise generated by the vibration member and helping reduce the noise of the vibration assembly.

In some embodiments, the inner layer includes a sound absorbing portion and a vibration attenuation portion that is disposed in a staggered manner with the sound absorbing portion. For example, the sound absorbing portion is located at a circumferential edge of the vibration attenuation portion. The vibration attenuation portion is in contact with the intermediate layer; the sound absorbing portion and the intermediate layer are disposed at an interval; and the micro via holes are located in the sound absorbing portion. The vibration attenuation portion is not provided with a micro via hole.

In some embodiments, the intermediate layer is provided with a sound absorbing cavity running through the intermediate layer. The sound absorbing cavity is communicated with the micro via holes, and the sound absorbing cavity is formed corresponding to the sound absorbing portion. It can be understood that an orthographic projection of the intermediate layer on the inner layer and the sound absorbing portion are staggered, that is, the projection of the intermediate layer on the inner layer does not overlap the sound absorbing portion. In this case, a gap is formed between the sound absorbing portion of the inner layer and the outer layer, so that the sound absorbing cavity communicated with the micro via holes is formed in the housing. For example, a shape of the intermediate layer is the same as that of the vibration attenuation portion.

In this embodiment of this application, the intermediate layer and the sound absorbing portion of the inner layer are staggered, and the sound absorbing cavity is formed between the sound absorbing portion and the outer layer. That is, gaps are arranged on both inner and outer sides of the sound absorbing portion in the inner layer. The plurality of micro via holes of the sound absorbing portion have a ventilation property. In this case, a micro-perforated plate sound absorbing structure is formed for the housing, and the sound waves (noise) generated by the vibration member enter the sound absorbing cavity between the intermediate layer and the sound absorbing portion from the micro via holes. Air in the sound absorbing cavity generates intense vibration and friction. In this way, the sound energy is converted into heat energy, and the heat energy is dissipated, thereby further improving the noise reduction effect of the vibration assembly.

In some embodiments, a porosity rate of the micro via holes formed in the sound absorbing portion ranges from 0.5% to 5%. The porosity rate of the micro via hole is a ratio of a total area of the micro via holes in the sound absorbing portion to a total area of the sound absorbing portion (also referred to as an effective mass transfer region). In the range of 0.5% to 5%, any value between 0.5% and 5% is included, and end values of 0.5% and 5% are also included.

In this embodiment of this application, the porosity rate of the micro via holes ranges from 0.5% to 5% to avoid that the noise reduction effect of the micro via holes is affected by sound quality of the inner layer because of an extremely large porosity rate of the micro via holes.

In some embodiments, the vibration attenuation portion includes a first vibration attenuation portion and a second vibration attenuation portion. For example, the sound absorbing portion is arranged around circumferential edges of the first vibration attenuation portion and the second vibration attenuation portion. The first vibration attenuation portion is connected to the second vibration attenuation portion by using a connection portion to avoid increasing a difficulty in assembling of the housing because the first vibration attenuation portion is disconnected from the second vibration attenuation portion, thereby reducing a difficulty in a process of preparing the housing. In this embodiment of this application, a quantity of vibration attenuation portions is not limited in this application. The quantity of vibration attenuation portions can be set based on a vibration manner of the vibration member.

In some embodiments, the intermediate layer includes a flat portion and a protruding portion protruding from one side of the flat portion. The protruding portion protrudes from one side of the flat portion close to the inner layer. The protruding portion is in contact with the vibration attenuation portions, and the flat portion and the sound absorbing portion are disposed at an interval. For example, the flat portion and the protruding portion are integrally formed to save the process for preparing the intermediate layer

It can be understood that an orthographic projection of the protruding portion on the inner layer and the sound absorbing portion are staggered, that is, the projection of the protruding portion on the inner layer does not overlap the sound absorbing portion. In this case, a gap is formed between the sound absorbing portion of the inner layer and the intermediate layer, so that the cavity communicated with the micro via holes is formed in the housing. For example, a shape of the protruding portion is the same as that of the vibration attenuation portion.

In this embodiment, the protruding portion protruding towards the inner layer is arranged in the intermediate layer, so that the cavity communicated with the micro via holes is formed between the intermediate layer and the inner layer. The plurality of micro via holes of the sound absorbing portion have a ventilation property. In this case, a micro-perforated plate sound absorbing structure is formed for the housing, and the sound waves (noise) generated by the vibration member enter the cavity between the intermediate layer and the sound absorbing portion from the micro via holes. Air in the cavity generates intense vibration and friction. In this way, the sound energy is converted into heat energy, and the heat energy is dissipated, thereby further improving the noise reduction effect of the vibration assembly.

According to a fifth aspect, this application provides a vibration assembly. The vibration assembly includes a vibration member and the housing according to the fourth aspect. The vibration assembly is a powertrain, a charging apparatus, a power distribution box, a self-driving hardware platform, a battery management system, or an intelligent cockpit. In this embodiment of this application, an example in which the vibration assembly is a powertrain is used for description. The vibration assembly includes a vibration member and the housing described above. The housing is mounted on the vibration member.

In this embodiment of this application, the above housing used in the vibration assembly can effectively convert mechanical vibration energy generated by a vibration member into heat energy for dissipation, thereby reducing vibration transferred by the vibration assembly to the outside, and helping reduce noise generated by the vibration assembly.

In some embodiments, the vibration member is provided with a first vibration region and a second vibration region. When the vibration assembly is in a working state, vibration of the first vibration region is greater than vibration of the second vibration region. It can be understood that vibration of the first vibration region is greater than vibration of the second vibration region. In this case, noise generated in the first vibration region is greater than that generated in the second vibration region.

In some embodiments, the micro via holes are formed corresponding to the second vibration region, and an orthographic projection of at least part of the intermediate layer on the vibration member is located in the first vibration region. The micro via holes are located in the sound absorbing portion in the inner layer. The micro via holes are formed corresponding to the second vibration region. The sound absorbing portion is located in the second vibration region. It can be understood that the vibration attenuation portion is located in the region (the first vibration region) of the vibration member that has relatively great vibration. The orthographic projection of at least part of the intermediate layer on the vibration member is located in the first vibration region, that is, at least part of the intermediate layer is in contact and stacked with the vibration attenuation portion. When the material used for the intermediate layer includes the polymer material, at least part of the intermediate layer is stacked with the vibration attenuation portion, so that the intermediate layer using the polymer material is correspondingly arranged in the region of the vibration member that has great vibration.

In this embodiment of this application, the inner layer, provided with the micro via holes, in the housing is disposed corresponding to the second vibration region, and the vibration attenuation portion, not provided with a micro via hole, in the inner layer is located in the region (the first vibration region) of the vibration member that has relatively great vibration. Because the intermediate layer is in contact with the vibration attenuation portion of the inner layer, great vibration energy generated by the vibration member can be effectively converted into heat energy for dissipation by using the vibration attenuation portion and the intermediate layer, thereby further improving the noise reduction performance of the vibration assembly.

According to a sixth aspect, this application further provides a vibration assembly. The vibration assembly includes a vibration member and a housing located on an outer side of the vibration member. The housing includes an outer layer, an intermediate layer, and an inner layer. The outer layer is located on an appearance side of the housing; the intermediate layer is located between the outer layer and the inner layer; and at least one of the intermediate layer and the inner layer includes a polymer material, and the other one includes a metal material. For example, the polymer material includes rubber, asphalt, a high-molecular polymer, high polymer resin, or the like. The polymer material may be a viscoelastic material, for example, rubber, asphalt, a high-molecular polymer, or high polymer resin, or may be a plastic material, for example, general engineering plastic or special engineering plastic.

It can be understood that in some embodiments, a material used for the intermediate layer includes a polymer material, and materials used for the outer layer and the inner layer include metal materials. In this embodiment, both the outer layer and the inner layer are made of metal materials. The inner layer of the housing can be in direct contact with a bottom housing of the vibration member, thereby achieving a grounding purpose and facilitating an electromagnetic shield design. The metal material may be but is not limited to steel or aluminum. In some other embodiments, a material used for the intermediate layer includes a metal material, and materials used for the outer layer and the inner layer include polymer materials. It can be understood that when a non-inner-layer structure (the outer layer or the intermediate layer) in the housing uses the metal material, an edge structure of the housing needs to be improved to make the outer layer in electrical contact with the bottom housing of the vibration member to achieve the grounding purpose. In this case, the electromagnetic shield design of the housing is relatively complex.

In this embodiment of this application, at least one of the intermediate layer and the outer layer of the housing includes the polymer material, and the other one includes the metal material. This not only can effectively convert mechanical vibration energy generated by the vibration member into heat energy for dissipation to reduce noise generated by the vibration assembly, but also can shield an electromagnetic signal to improve an electromagnetic shield capability of the vibration assembly.

According to a seventh aspect, this application further provides a vibration assembly. The vibration assembly includes a vibration member and a housing. The housing is located at a circumferential edge of the vibration member. The housing includes a shield layer and a plastic layer. A material used for the shield layer includes a metal material. A material used for the plastic layer includes a plastic material. A damping coefficient of the plastic layer is greater than or equal to 0.05. For example, the material used for the plastic layer includes polycarbonate (polycarbonate, PC), polyphenylene sulfide (phenylenesulfide, PPS), ABS plastic (acrylonitrile butadiene styrene plastic, ABS), or polyamide 66 plastic (polyamide 66). The plastic layer may include some additives, such as a glass fiber, a carbon fiber, or an asbestos fiber.

In this embodiment of this application, the housing includes the plastic layer with the damping coefficient greater than or equal to 0.05, and mechanical vibration energy generated by the vibration member can be converted into heat energy for dissipation, thereby reducing vibration transferred by the vibration assembly to the outside, and helping reduce noise generated by the vibration assembly. In addition, costs of using the plastic material for the plastic layer are relatively low. This can effectively reduce costs of the housing and facilitate large-scale production of the housing. The housing includes the shield layer to improve an electromagnetic shield capability of the vibration assembly.

In some embodiments, the housing further includes a sound insulation layer. The sound insulation layer is located between the shield layer and the plastic layer, and the plastic layer is located on one side of the isolation layer close to the vibration member. A sound absorbing cavity is formed between the shield layer and the plastic layer. The plastic layer is provided with a plurality of through holes formed at intervals, and the through holes are communicated with the sound absorbing cavity. In this embodiment, an orthographic projection of the sound insulation layer on the plastic layer is located only in part of a region of the plastic layer, so that the shield layer and the plastic layer are disposed at an interval to form the sound absorbing cavity. For example, the sound insulation layer is located only in an intermediate region of the housing, and the sound absorbing cavity encloses a circumferential edge of the sound insulation layer. In other embodiments, for structures of the sound insulation layer and the plastic layer, refer to the structures of the intermediate layer and the inner layer in the foregoing embodiments. Details are not described herein again.

In this embodiment of this application, the sound insulation layer and the sound absorbing portion of the plastic layer are staggered, and the cavity is formed between the sound absorbing portion and the outer layer. That is, gaps are arranged on both inner and outer sides of the sound absorbing portion in the plastic layer. The plurality of small through holes of the sound absorbing portion have a ventilation property. In this case, a micro-perforated plate sound absorbing structure is formed for the housing, and the sound waves (noise) generated by the vibration member enter the cavity between the sound insulation layer and the sound absorbing portion from the through holes. Air in the cavity generates intense vibration and friction. In this way, the sound energy is converted into heat energy, and the heat energy is dissipated, thereby further improving the noise reduction effect of the vibration assembly.

In other embodiments, when the plastic layer is located on one side of the shield layer away from the vibration member, the shield layer is provided with a plurality of through holes formed at intervals, and a sound absorbing cavity is formed between the sound insulation layer and the shield layer. The sound absorbing cavity is communicated with the through holes, so that a micro-perforated plate sound absorbing structure is formed for the housing. It can be understood that the through holes are arranged on one side of the housing closest to the vibration member, and the sound absorbing cavity is formed on the intermediate layer structure of the housing.

A stacking order of the shield layer and the plastic layer is not limited in this application. In some implementations, the plastic layer is located on an inner side of the housing, that is, the plastic layer is located on one side of the shield layer close to the vibration member. In some other implementations, the plastic layer is located on an outer side of the housing, that is, the plastic layer is located on one side of the shield layer away from the vibration member. In this embodiment of this application, an example in which the plastic layer is located on the inner side of the housing is used for description.

In some embodiments, the shield layer may be formed on the plastic layer by using an electroplating process. In some other embodiments, the shield layer and the plastic layer can also be integrally formed. For example, the shield layer and the plastic layer are integrally formed by using an intra-film injection molding process to simplify a molding process of the housing. The shield layer may be provided with a hole. This is not limited in this application. For example, the shield layer may alternatively be a metal mesh, so that a weight of the housing is reduced while electromagnetic compatibility protection of the vibration assembly is improved.

In some embodiments, a thickness of the plastic layer is greater than or equal to that of the shield layer. In some embodiments, a thickness of the plastic layer is greater than or equal to 1 mm.

According to an eighth aspect, this application further provides a vibration assembly. The vibration assembly includes a vibration member, a shield member, a bottom housing, and a cover plate. The bottom housing is provided with an accommodation space. Both the vibration member and the shield member are accommodated in the accommodation space, and the shield member is located above the vibration member. The cover plate is located above the shield member, and covers the bottom housing. A material used for the shield member includes a metal material, and a material used for the cover plate includes a polymer material.

In this embodiment, the shield member, configured to shield an electromagnetic signal, in the vibration assembly is accommodated in the accommodation space formed by the bottom housing. In this case, the cover plate can be made of an all-polymer material and is relatively thick, thereby improving performance of the cover plate for dissipating mechanical vibration generated by the vibration member and further improving vibration attenuation and noise reduction effects of the vibration assembly.

In this embodiment of this application, the thickness of the plastic layer is greater than that of the shield layer. The plastic layer can alternatively be relatively thick on the basis of ensuring that the housing is relatively thin. Therefore, mechanical vibration of the housing can be effectively dissipated to reduce noise.

According to a ninth aspect, this application further provides a vehicle. The vehicle includes a vehicle body and the vibration assembly as described above. The vehicle body is mounted on the vibration assembly. The vehicle may be an electric vehicle, or may be a fuel vehicle. This is not limited in this application.

In the embodiments of this application, the vibration assembly in the vehicle includes a vibration member and a housing located on an outer side of the vibration member. A material used for the housing includes a polymer material. The housing effectively converts mechanical vibration energy generated by the vibration member into heat energy for dissipation, which reduces vibration transferred by the vibration assembly to the outside, and helps reduce noise generated by the vibration assembly, thereby improving noise, vibration, and harshness performance of the vehicle.

### BRIEF DESCRIPTION OF DRAWINGS

To describe technical solutions in embodiments of this application or in the background, the following briefly describes the accompanying drawings for describing the embodiments of this application or the background.
FIG. 1 is a schematic diagram of a structure of a vehicle according to an embodiment of this application;
FIG. 2 is a schematic diagram of a structure of a vibration assembly shown in FIG. 1;
FIG. 3 is a schematic diagram of a partial structure of a housing shown in FIG. 2 in Embodiment 1;
FIG. 4 is a schematic diagram of an enlarged structure of portion A shown in FIG. 3;
FIG. 5 is a schematic diagram of a partially exploded structure of the housing shown in FIG. 3 in a first implementation;
FIG. 6 is a schematic diagram of a partially exploded structure of the housing shown in FIG. 3 in a second implementation;
FIG. 7 is a schematic diagram of a partial cross section of the housing shown in FIG. 6;
FIG. 8 is a schematic diagram of a structure of the housing shown in FIG. 6 from another angle;
FIG. 9 is a top view of the housing shown in FIG. 3 in a third implementation;
FIG. 10 is a top view of the housing shown in FIG. 3 in a fourth implementation;
FIG. 11 is a schematic diagram of a partially exploded structure of the housing shown in FIG. 3 in a fifth implementation;
FIG. 12 is a schematic diagram of a partially exploded structure of a housing shown in FIG. 2 in Embodiment 2;
FIG. 13 is a schematic diagram of a partial structure of a housing shown in FIG. 2 in Embodiment 3;
FIG. 14 is a schematic diagram of an enlarged structure of portion B shown in FIG. 13;
FIG. 15 is a schematic diagram of a partial cross section of the housing shown in FIG. 13 in a first implementation;
FIG. 16 is a schematic diagram of a cross section of the housing shown in FIG. 13 in a second implementation;
FIG. 17 is a schematic diagram of a cross section of the housing shown in FIG. 13 in a third implementation;
FIG. 18 is a schematic diagram of a cross section of the housing shown in FIG. 13 in a fourth implementation;
FIG. 19 is a top view of the housing shown in FIG. 13 in a fifth implementation;
FIG. 20 is a schematic diagram of a cross section of the housing shown in FIG. 19;
FIG. 21 is a schematic diagram of a cross section of the housing shown in FIG. 13 in a sixth implementation; and
FIG. 22 is a schematic diagram of a partial cross section of a vibration assembly shown in FIG. 1 in another embodiment.

### DESCRIPTION OF EMBODIMENTS

The following describes embodiments of this application with reference to the accompanying drawings in the embodiments of this application.

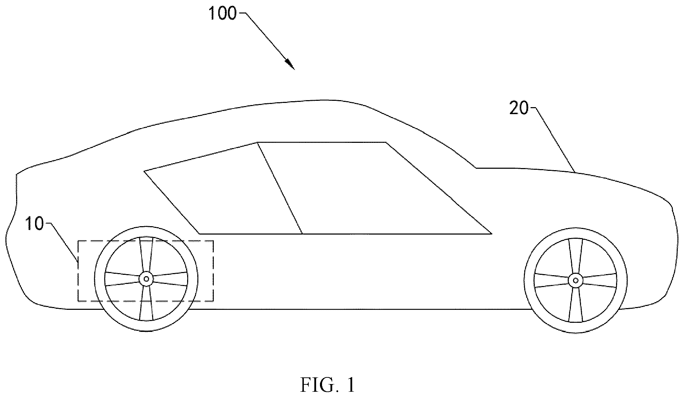

Refer to FIG. 1. FIG. 1 is a schematic diagram of a structure of a vehicle 100 according to an embodiment of this application. The vehicle 100 is a wheeled vehicle 100 that is driven or pulled by a power apparatus and used by a person to travel on a road or configured to transport objects and perform special engineering operations. The vehicle 100 may be an electric vehicle, or may be a fuel vehicle. This is not limited in this application. In this embodiment of this application, an example in which the vehicle 100 is an electric vehicle is used for description.

As shown in FIG. 1, the vehicle 100 includes a vibration assembly 10 and a vehicle body 20. The vehicle body 20 is mounted on the vibration assembly 10. In some states, for example, when the vehicle 100 is running, some structures in the vibration assembly 10 vibrate. For example, the vibration assembly 10 is a powertrain, a charging apparatus, a power distribution box, a self-driving hardware platform, a battery management system, or an intelligent cockpit. In this embodiment of this application, an example in which the vibration assembly 10 is a powertrain is used for description.

The powertrain is a series of parts and components, on the vehicle 100, that generate power and transfer the power to a road surface. For example, when the powertrain is in a working state, a rotor in the powertrain rotates to generate power, and the power is transferred to wheels to drive the vehicle 100 to move forward. In a broad sense, the powertrain includes an engine, a gearbox, a drive shaft, a differential mechanism, a clutch, and the like. However, in a general case, the powertrain is only an engine, a transmission, and another part integrated to the transmission, such as a clutch or a front differential mechanism. For example, for a conventional internal combustion engine, the powertrain is an engine and a gearbox. For an electric vehicle, the powertrain is a motor, a reducer, and a motor controller.

In this embodiment of this application, an example in which the vibration assembly 10 is applied to the vehicle 100 is used for description. In other embodiments, the vibration assembly 10 can also be used in other electronic devices, for example, household appliances such as a washing machine, a microwave oven, or an air conditioner. This is not limited in this application.

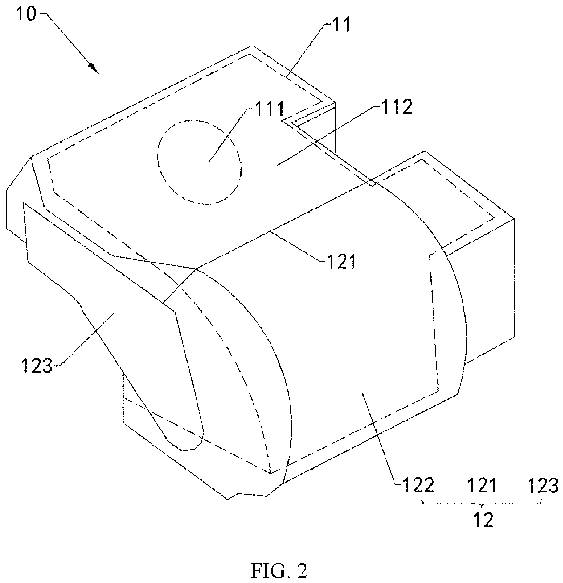

Refer to FIG. 1 and FIG. 2 together. FIG. 2 is a schematic diagram of a structure of the vibration assembly 10 shown in FIG. 1. The vibration assembly 10 includes a vibration member 11 and a housing 12. The vibration member 11 can generate vibration. The vibration generated by the vibration member 11 may be continuous reciprocating vibration, or may be intermittent irregular vibration. This is not limited in this application. An amplitude, a frequency, time, and the like of the vibration of the vibration member 11 are not limited in this application.

When the vibration member 11 works, noise is generated due to vibration, which affects noise, vibration, and harshness (noise, vibration, and harshness, NVH) performance of the vehicle. For example, when the rotor in the powertrain rotates to generate power, sizzling high-frequency electromagnetic noise is generated, and the generated noise is transferred out of the vibration assembly 10 by using the housing 12, affecting comfort of a driver. For example, the vibration member 11 is an element that vibrates in the powertrain, for example, a gear, a rotor, or a motor. When some elements of the vehicle 100 close to the powertrain vibrate together under the action of the vibration of the powertrain, the elements close to the powertrain may also be defined as vibration members 11.

The housing 12 is mounted on an outer side of the vibration member 11. In this embodiment of this application, the housing 12 is located on the outer side of the vibration member 11, and not only can be configured to protect the vibration member 11, but also can reduce the noise transferred by the vibration member 11 out of the housing 12 in the vibration process, thereby facilitating noise reduction of the vibration assembly 10.

In some embodiments, the vibration member 11 is provided with a first vibration region 111 and a second vibration region 112. When the vibration assembly 10 is in a working state, vibration of the first vibration region 111 is greater than vibration of the second vibration region 112. It can be understood that vibration of the first vibration region 111 is greater than vibration of the second vibration region 112. In this case, noise generated in the first vibration region 111 is greater than that generated in the second vibration region 112. For example, a structure of the housing 12 corresponding to the first vibration region 111 is different from a structure of the housing 12 corresponding to the second vibration region 112, and a noise reduction effect of the structure of the housing 12 corresponding to the first vibration region 111 is better than a noise reduction effect of the structure of the housing 12 corresponding to the second vibration region 112 to effectively reduce the noise transferred by the vibration member 11 from the housing 12 to the outside of the vibration assembly 10.

In some embodiments, a magnitude of vibration of each region of the vibration member 11 is determined by detecting the noise in each region of the vibration member 11. For example, a simulation test is performed on the vibration assembly. A frequency corresponding to a point with large noise is first determined; a modal formation of the housing 12 corresponding to the frequency is then determined; and a region of the magnitude of the vibration of the vibration member 11 is determined based on the modal formation of the housing 12. For example, when the modal formation of the housing 12 is a first-order modal, an intermediate region of the housing 12 has maximum vibration, and the first vibration region 111 is located in the intermediate region of the housing 12.

In this embodiment of this application, an example in which the vibration assembly 10 is a powertrain is used for description. In this case, the vibration member 11 is provided with the first vibration region 111 and the second vibration region 112 with different magnitudes of vibration. When the vibration assembly 10 is another component, the vibration member 11 may alternatively not include the first vibration region 111 and the second vibration region 112. This is not limited in this application.

As shown in FIG. 2, in some embodiments, the housing 12 includes a first housing 121, a second housing 122, and a third housing 123. The first housing 121, the second housing 122, and the third housing 123 are respectively located in different directions of the vibration member 11. For example, the first housing 121 is located above the vibration member 11. It can be understood that the first housing 121 is a cover plate of the vibration member 11. The second housing 122 and the third housing 123 are located on a side edge of the vibration member 11. It can be understood that the second housing 122 and the third housing 123 are side plates of the vibration member 11.

In this embodiment of this application, the first housing 121 and the second housing 122 are generally flat, and the third housing 123 is curved, so that shapes of the first housing 121, the second housing 122, and the third housing 123 match a shape of the vibration member 11, thereby facilitating miniaturization of the vibration assembly 10.

In this embodiment of this application, the example in which the vibration assembly 10 is the powertrain is used for description. In this case, the housing 12 includes the first housing 121, the second housing 122, and the third housing 123. In other embodiments, the housing 12 may alternatively include only the first housing 121. This is not limited in this application. That is, the composition, the shape, and the like of the housing 12 are not limited in this application. Materials used for the first housing 121, the second housing 122, and the third housing 123 may be the same or different. This is not limited in this application. For example, in some embodiments, the materials used for the first housing 121, the second housing 122, and the third housing 123 are the same. In some other embodiments, the materials used for at least two of the first housing 121, the second housing 122, and the third housing 123 are different.

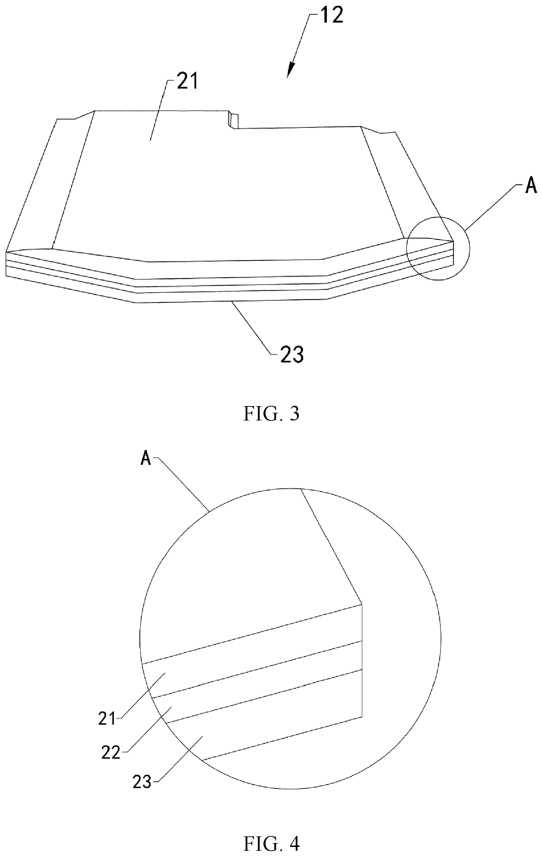

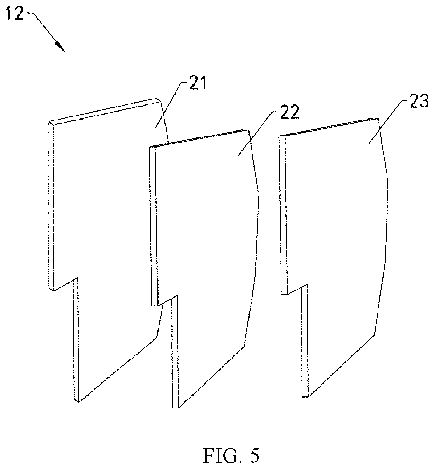

Refer to FIG. 3 to FIG. 5. FIG. 3 is a schematic diagram of a partial structure of the housing 12 shown in FIG. 2 in Embodiment 1; FIG. 4 is a schematic diagram of an enlarged structure of a portion A shown in FIG. 3; and FIG. 5 is a schematic diagram of a partially exploded structure of the housing 12 shown in FIG. 3 in a second implementation. Specifically, FIG. 3 shows a schematic diagram of the structure of the first housing 121 in the housing 12.

The first housing 121 includes an outer layer 21, an intermediate layer 22, and an inner layer 23. The outer layer 21 is an appearance side of the first housing 121. The inner layer 23 and the outer layer 21 are disposed opposite to each other, and the intermediate layer 22 is located between the outer layer 21 and the inner layer 23. It can be understood that the outer layer 21 is an outermost layer 21 of the first housing 121; the inner layer 23 is an innermost layer 23 of the first housing 121; and the intermediate layer 22 is located between the outer layer 21 and the inner layer 23. The layer structures of the second housing 122 and the third housing 123 may be the same as that of the first housing 121, or may be different from that of the second housing 122. This is not limited in this application.

A quantity of layers of the intermediate layer 22 is not limited in this application. For example, the intermediate layer 22 may be of a single-layer structure, or may be of a multi-layer structure. In addition, in addition to the intermediate layer 22, other layer structures may be further included between the outer layer 21 and the inner layer 23. This is not limited in this application. It can be understood that in Embodiment 1 provided in this application, the first housing 121 includes at least three layers.

In some implementations, the outer layer 21, the intermediate layer 22, and the inner layer 23 are sequentially bonded by using bonding layers, to form a combined layer structure. A material used for the bonding layer may be but is not limited to a solid-state adhesive (for example, a double-sided adhesive tape) or liquid glue (for example, super glue). For example, a metal fixing hole is further formed on an edge of the first housing 121, and the fastener passes through the fixing hole to fasten the outer layer 21, the intermediate layer 22, and the inner layer 23, thereby improving reliability of the housing 12. Edge wrapping processing may be or may not be performed on the edge of the first housing 121. This is not limited in this application. In some other implementations, the outer layer 21, the intermediate layer 22, and the inner layer 23 may alternatively be integrally formed. For example, the outer layer 21, the intermediate layer 22, and the inner layer 23 are integrally formed by using an intra-film injection molding process to simplify a molding process of the housing 12. In some other implementations, the outer layer 21 may alternatively be a plated layer. This is not limited in this application.

In some embodiments, a material used for the outer layer 21 includes a metal material to improve electromagnetic compatibility (electromagnetic compatibility, EMC) protection. The electromagnetic compatibility is a capability of a device or system of running in an electromagnetic environment as required without generating unbearable electromagnetic interference to any device in the environment. It can be understood that shielding is to perform metal isolation between two space regions to control induction and radiation of an electric field, a magnetic field, and electromagnetic waves from one region to another region. Specifically, interference sources of components, circuits, assemblies, cables, or an entire system are wrapped by using shield bodies to prevent an interference electromagnetic field from spreading. A receiving circuit, a device, or a system is wrapped by using a shield body to prevent the receiving circuit, the device, or the system from being affected by an external electromagnetic field.

In this embodiment, the outer layer 21 is used as a metal shield layer to avoid an electromagnetic signal generated by the vibration member 11 from interfering with an electronic element outside the vibration assembly 10, and also avoid an electromagnetic signal generated by an electronic element outside the vibration assembly 10 from interfering with the vibration member 11 inside the vibration assembly 10. The outer layer 21 may use one or more materials. This is not limited in this application. For example, a metal material used for the outer layer 21 is not limited to copper, aluminum, an alloy, or the like. The alloy may be high damping alloy.

In some embodiments, a material used for the intermediate layer 22 includes a polymer material. In this application, a damping coefficient of the intermediate layer 22 using the polymer material is greater than that of the outer layer 21 using the metal material. For example, the damping coefficient of the intermediate layer 22 using the polymer material may be greater than or equal to 0.05. A damping coefficient is a standard for measuring a damping magnitude of a polymer material. A larger damping coefficient indicates better damping performance of the polymer material and a higher ability to dissipate vibration energy. Due to the characteristics, the polymer material may be usually a viscoelastic material, for example, rubber, asphalt, a high-molecular polymer, or high polymer resin, or may be a plastic material, for example, general engineering plastic or special engineering plastic. The general engineering plastic mainly includes five types of general engineering plastic, namely, polyamide, polycarbonate, polyformaldehyde, modified polyether, and thermoplastic polyester. The special engineering plastic is mainly engineering plastic with a heat resistance of more than 150°C, and mainly includes polyimide, polyphenylene sulfide, polysulfone, aromatic polyamide, polyarylate, polybenzoate, polyaryletherketone, a liquid crystal polymer, fluorine resin, and the like. For example, the polymer material may alternatively be plastic such as polycarbonate (polycarbonate, PC), polyphenylene sulfide (phenylenesulfide, PPS), ABS plastic (acrylonitrile butadiene styrene plastic, ABS), or polyamide 66 plastic (polyamide 66). The ABS plastic is a ternary copolymer of three monomers: acrylonitrile, butadiene, and styrene. Relative contents of the three monomers can change flexibly to make various resins. The polyamide 66 is formed by condensing hexanedioic acid and hexadiamine. The polycarbonate (polycarbonate, PC) is a colorless and transparent non-qualitative thermoplastic material. A person skilled in the art may select a proper polymer material based on a requirement of an actual product.

In this embodiment of this application, the polymer material used in the intermediate layer 22 of the housing 12 can effectively convert mechanical vibration energy generated by the vibration member 11 into heat energy for dissipation, thereby reducing vibration transferred by the vibration assembly 10 to the outside, helping reduce noise generated by the vibration assembly 10, and improving noise, vibration, and harshness performance of the vehicle 100. When the intermediate layer 22 of the housing 12 uses the plastic material, vibration of the housing 12 can be effectively reduced. Furthermore, because costs of the plastic material are relatively low, costs of the housing 12 can be effectively reduced, thereby facilitating large-scale production of the housing 12.

In some embodiments, when a material used for the intermediate layer 22 includes a polymer material, and the material used for the outer layer 21 includes the metal material, a thickness of the intermediate layer 22 is greater than or equal to that of the outer layer 21. For example, when a material used for the inner layer 23 includes a metal material, the thickness of the intermediate layer 22 is also greater than or equal to that of the inner layer 23. In some embodiments, a thickness of the intermediate layer 22 is greater than or equal to 1 mm. For example, the thickness of the intermediate layer 22 is 2 mm; the thickness of the outer layer 21 is 0.5 mm; and the thickness of the inner layer is 0.5 mm.

In this embodiment of this application, the thickness of the intermediate layer 22 using the polymer material is greater than that of the outer layer 21 using the metal layer. The polymer layer can alternatively be relatively thick on the basis of ensuring that the housing 12 is relatively thin. Therefore, mechanical vibration of the housing 12 can be effectively dissipated to reduce noise. For example, when a total thickness of the housing 12 is 3 mm, the thickness of the intermediate layer 22 can be greater than or equal to 1 mm to ensure the thickness of the polymer layer.

In some other embodiments, a material used for the inner layer 23 includes a polymer material. For example, a damping coefficient of the inner layer 23 is greater than or equal to 0.05. The polymer material may be a viscoelastic polymer material, for example, rubber, asphalt, a high-molecular polymer, or high polymer resin, or may be a plastic material.

In this embodiment of this application, the polymer material used in the inner layer 23 of the housing 12 can effectively convert mechanical vibration energy generated by the vibration member 11 into heat energy for dissipation, thereby reducing vibration transferred by the vibration assembly 10 to the outside, and helping reduce noise generated by the vibration assembly 10. When the inner layer 23 of the housing 12 uses the plastic material, vibration of the housing 12 can be effectively reduced. Furthermore, because costs of the plastic material are relatively low, costs of the housing 12 can be effectively reduced, thereby facilitating large-scale production of the housing 12.

It can be understood that in this embodiment of this application, at least one of the intermediate layer 22 and the inner layer 23 includes the polymer material, that is, a non-outer layer 21 (the intermediate layer 22 and/or the inner layer 23) of the housing 12 includes the polymer material to reduce a vibration magnitude of the housing 12 and reduce noise. When the material used for the inner layer 23 includes the polymer material, the material used for the intermediate layer 22 of the housing 12 may be the polymer material, or may be another material. This is not limited in this application. For example, in this embodiment of this application, an example in which the material used for the outer layer 21 includes the metal material, the material used for the intermediate layer 22 is the polymer material, and the material used for the inner layer 23 includes the metal material is used for description. In other embodiments, a material used for the outer layer 21 includes a metal material, a material used for the intermediate layer 22 includes a metal material, and a material used for the inner layer 23 includes a polymer material; or a material used for the outer layer 21 includes a polymer material, a material used for the intermediate layer 22 includes a metal material, and a material used for the inner layer 23 includes a polymer material.

In this embodiment of this application, when one of the inner layer 23 and the intermediate layer 22 uses the polymer material, and the other one uses the metal material, the housing 12 has relatively high structural strength and is not easy to fall. This helps improve long-term reliability of the housing 12.

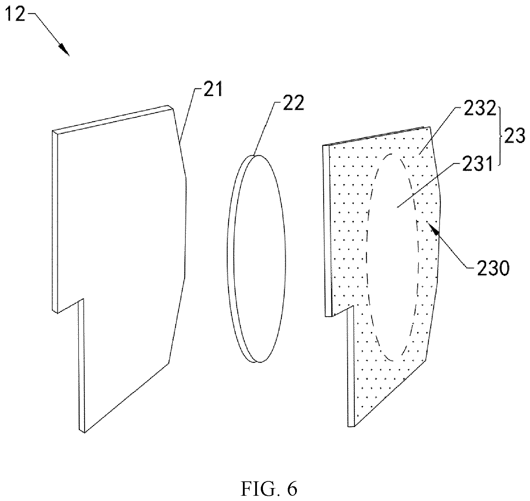

Refer to FIG. 6. FIG. 6 is a schematic diagram of a partially exploded structure of the housing 12 shown in FIG. 3 in a second implementation. In this implementation, the vibration assembly 10 includes most technical features of the first implementation, and content of most technical solutions of this implementation that are the same as those in the foregoing implementation in the following is not described again. For example, the housing 12 includes an outer layer 21, an intermediate layer 22, and an inner layer 23 that are disposed in sequence. At least one of the intermediate layer 22 and the inner layer 23 includes a polymer material. For example, the polymer material may be a viscoelastic material, for example, rubber, asphalt, a high-molecular polymer, or high polymer resin, or may be a plastic material, for example, general engineering plastic or special engineering plastic.

The inner layer 23 is provided with a plurality of micro via holes 230 formed at intervals. The micro via holes 230 only run through the inner layer 23 and do not extend to the intermediate layer 22. For example, an aperture of each micro via hole 230 is less than or equal to 1 mm. In FIG. 6, a plurality of points disposed at intervals are used to indicate the plurality of micro via holes 230 formed at intervals, but do not indicate an actual aperture of each micro via hole 230. In some embodiments, when the aperture of the micro via hole 230 is relatively small, for example, at a nanometer level, the plurality of micro via holes 230 formed in the inner layer 23 at intervals cannot be observed with naked eyes.

In this embodiment of this application, the inner layer 23 is provided with the plurality of micro via holes 230 that are formed at intervals. Many run-through small gaps are formed in the inner layer 23. Sound waves (noise) generated by the vibration member 11 change with expansion and retraction of air when entering the micro via holes 230, and vibrate on hole walls of the micro via holes 230 to generate friction. Due to effects of viscous damping and friction for heat generation of the inner layer 23 itself, sound energy is continuously converted into heat energy and dissipated, thereby reducing the noise generated by the vibration member 11 and helping reduce the noise of the vibration assembly 10.

As shown in FIG. 6, in this embodiment of this application, an example in which the micro via holes 230 are located only in a part of a region of the inner layer 23 is used for description. In other embodiments, the micro via holes 230 may alternatively be distributed in the full region of the inner layer 23. This is not limited in this application.

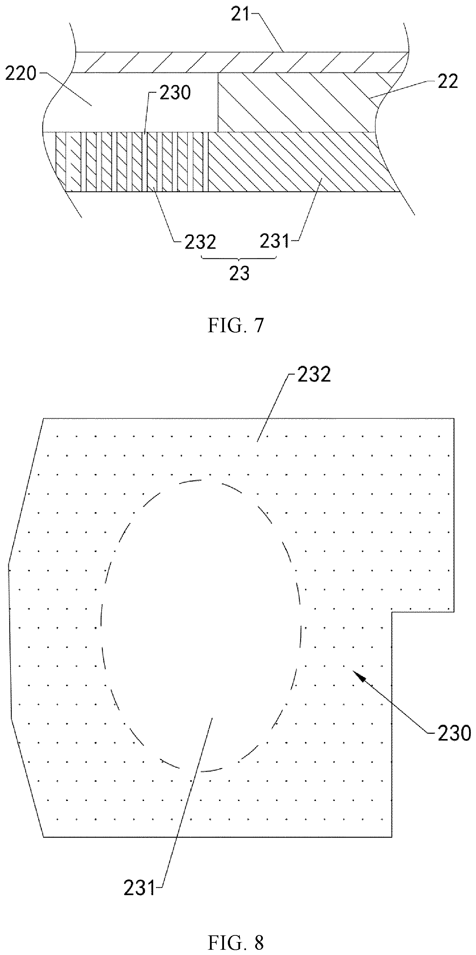

Refer to FIG. 6 to FIG. 8 together. FIG. 7 is a schematic diagram of a partial cross section of the housing 12 shown in FIG. 6; and FIG. 8 is a schematic diagram of a structure of the housing 12 shown in FIG. 6 from another angle. The inner layer 23 includes a sound absorbing portion 232 and a vibration attenuation portion 231 disposed in a staggered manner with the sound absorbing portion 232. The vibration attenuation portion 231 is in contact with the intermediate layer 22, and the sound absorbing portion 232 and the intermediate layer 22 are disposed at an interval. The micro via holes 230 are located in the sound absorbing portion 232. The vibration attenuation portion 231 is not provided with a micro via hole 230. For example, the sound absorbing portion 232 is located at a circumferential edge of the vibration attenuation portion 231.

With reference to FIG. 6 and FIG. 7, in some implementations, a sound absorbing cavity 220 running through the intermediate layer 22 is arranged at the intermediate layer 22. The sound absorbing cavity 220 is communicated with the micro via holes 230, and the sound absorbing cavity 220 is formed corresponding to the sound absorbing portion 232. For example, an orthographic projection of the intermediate layer 22 on the inner layer 23 and the sound absorbing portion 232 are disposed in a staggered manner, that is, the projection of the intermediate layer 22 on the inner layer 23 does not overlap the sound absorbing portion 232. In this case, a gap is formed between the sound absorbing portion 232 of the inner layer 23 and the outer layer 21, so that a sound absorbing cavity 220 communicated with the micro via holes 230 is formed for the housing 12. As shown in FIG. 6, a shape of the intermediate layer 22 is the same as that of the vibration attenuation portion 231.

In this embodiment of this application, the intermediate layer 22 and the sound absorbing portion 232 of the inner layer 23 are staggered, and the sound absorbing cavity 220 is formed between the sound absorbing portion 232 and the outer layer 21. That is, gaps are arranged on both inner and outer sides of the sound absorbing portion 232 in the inner layer 23. The plurality of micro via holes 230 of the sound absorbing portion 232 have a ventilation property. In this case, a micro-perforated plate sound absorbing structure is formed for the housing 12, and the sound waves (noise) generated by the vibration member 11 enter the sound absorbing cavity 220 between the intermediate layer 22 and the sound absorbing portion 232 from the micro via holes 230. Air in the sound absorbing cavity 220 generates intense vibration and friction. In this way, the sound energy is converted into heat energy, and the heat energy is dissipated, thereby further improving the noise reduction effect of the vibration assembly 10. In addition, the intermediate layer 22 is located only in part of the region of the housing 12, so that a raw material used for the intermediate layer 22 is reduced. This not only reduces the costs of the housing 12, but also helps reduce the weight of the housing 12.

With reference to FIG. 2 and FIG. 8, in some embodiments, the micro via holes 230 are formed corresponding to the second vibration region 112. The micro via holes 230 are located in the sound absorbing portion 232 in the inner layer 23, that is, the sound absorbing portion 232 in the inner layer 23 is located in the second vibration region 112, and the vibration attenuation portion 231 in the inner layer 23 is located in the first vibration region 111. Vibration of the first vibration region 111 is greater than that of the second vibration region 112, that is, the vibration attenuation portion 231 is located in the region of the vibration member 11 that has relatively great vibration. In some embodiments, an orthographic projection of at least part of the intermediate layer 22 on the vibration member 11 is located in the first vibration region 111.

It can be understood that the vibration attenuation portion 231 is located in the region (the first vibration region 111) of the vibration member 11 that has relatively great vibration. The orthographic projection of at least part of the intermediate layer 22 on the vibration member 11 is located in the first vibration region 111, that is, at least part of the intermediate layer 22 is in contact and stacked with the vibration attenuation portion 231. When the material used for the intermediate layer 22 includes the polymer material, at least part of the intermediate layer 22 is stacked with the vibration attenuation portion 231, so that the intermediate layer 22 using the polymer material is correspondingly arranged in the region of the vibration member 11 that has great vibration.

In this embodiment of this application, the inner layer 21, provided with the micro via holes 230, in the housing 12 is formed corresponding to the second vibration region 112, and the vibration attenuation portion 231, not provided with a micro via hole 230, in the inner layer 21 is located in the region (the first vibration region 111) of the vibration member 11 that has relatively great vibration. Because the intermediate layer 22 is in contact with the vibration attenuation portion 231, great vibration energy generated by the vibration member 11 can be effectively converted into heat energy for dissipation by using the vibration attenuation portion 231 and the intermediate layer 22, thereby further improving the noise reduction performance of the vibration assembly 10.

It can be understood that specific relative positions of the sound absorbing portion 232 and the vibration attenuation portion 231 are not limited in this application. A person skilled in the art can define the positions of the sound absorbing portion 232 and the vibration attenuation portion 231 based on magnitudes of vibration generated by the vibration member 11 in different regions.

In some embodiments, a porosity rate of the micro via holes 230 formed in the sound absorbing portion 232 ranges from 0.5% to 5%. The porosity rate of the micro via hole 230 is a ratio of a total area of the micro via holes 230 in the sound absorbing portion 232 to a total area of the sound absorbing portion 232 (also referred to as an effective mass transfer region). In the range of 0.5% to 5%, any value between 0.5% and 5% is included, and end values of 0.5% and 5% are also included.

In this embodiment of this application, the porosity rate of the micro via holes 230 ranges from 0.5% to 5% to avoid that the noise reduction effect of the micro via holes 230 is affected by sound quality of the inner layer 23 because of an extremely large porosity rate of the micro via holes 230.

This application does not limit the aperture and porosity rate of the micro via holes 230, the thickness of the inner layer 23, or the thickness of the intermediate layer 22. A person skilled in the art can design the micro via holes based on an actual requirement of the housing 12.

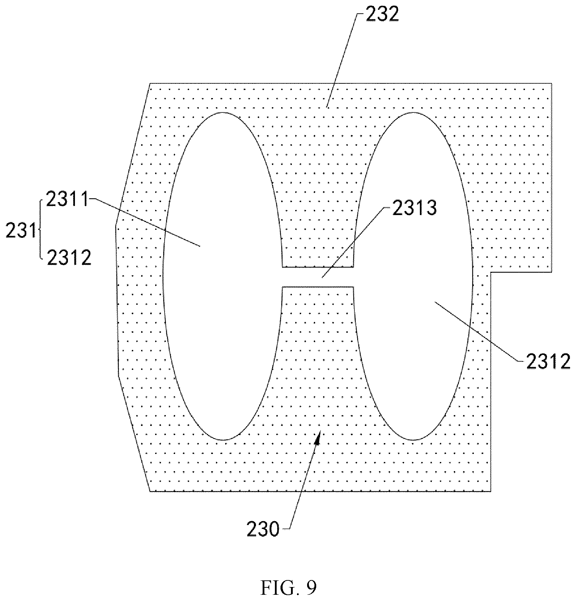

Refer to FIG. 8 and FIG. 9 together. FIG. 9 is a top view of the housing 12 shown in FIG. 3 in a third implementation. In this implementation, the vibration assembly 10 includes most technical features of the foregoing implementation, and content of most technical solutions of this implementation that are the same as those in the foregoing implementation in the following is not described again. For example, the housing 12 includes an outer layer 21, an intermediate layer 22, and an inner layer 23 that are disposed in sequence. The inner layer 23 includes a vibration attenuation portion 231 and a sound absorbing portion 232. The vibration attenuation portion 231 is in contact with the intermediate layer 22. The sound absorbing portion 232 and the intermediate layer 22 are disposed at an interval. The sound absorbing portion 232 is provided with a plurality of micro via holes 230 formed at intervals. A material used for the intermediate layer 22 and/or the inner layer 23 includes a polymer material.

In the third implementation, the vibration attenuation portion 231 includes a first vibration attenuation portion 2311 and a second vibration attenuation portion 2312. As shown in FIG. 9, the sound absorbing portion 232 is arranged around the first vibration attenuation portion 2311 and the second vibration attenuation portion 2312. For example, the first vibration attenuation portion 2311 is connected to the second vibration attenuation portion 2312 by using a connection portion 2313 to avoid increasing a difficulty in assembling of the housing 12 because the first vibration attenuation portion 2311 is disconnected from the second vibration attenuation portion 2312, thereby reducing a difficulty in a process of preparing the housing 12.

In this embodiment of this application, a quantity of vibration attenuation portions 231 is not limited in this application. The quantity of vibration attenuation portions 231 can be set based on a vibration manner of the vibration member 11. For example, as shown in FIG. 2 and FIG. 8, when the modal formation of the housing 12 is a first-order modal, there is one vibration attenuation portion 231, and the first vibration region 111 is located in an intermediate region of the housing 12. In this case, a projection of the intermediate layer 22 on the inner layer 23 is located in the intermediate region, that is, the intermediate layer 22 is located only in the intermediate region of the housing 12. As shown in FIG. 9, when the modal formation of the housing 12 is a second-order modal formation, there are two vibration attenuation portions 231, and the first vibration attenuation portion 2311 and the second vibration attenuation portion 2312 each correspond to the region of the vibration member 11 that has relatively great vibration.

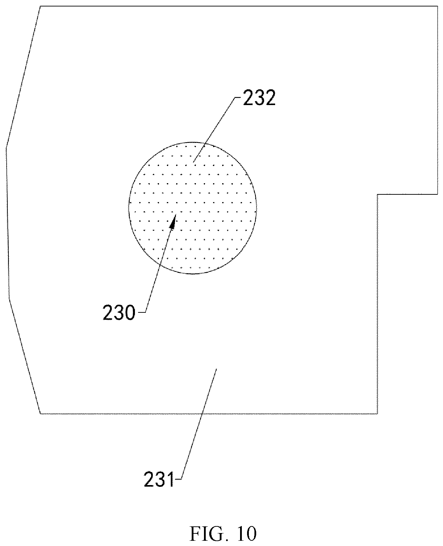

Refer to FIG. 10. FIG. 10 is a top view of the housing 12 shown in FIG. 3 in a fourth implementation. In this implementation, the vibration assembly 10 includes most technical features of the foregoing implementation, and content of most technical solutions of this implementation that are the same as those in the foregoing implementation in the following is not described again. In the fourth implementation, the vibration attenuation portion 231 is located at a circumferential edge of the sound absorbing portion 232. For example, the intermediate layer 22 is also of a hollow ring structure.

In this embodiment of this application, relative positions of the sound absorbing portion 232 and the vibration attenuation portion 231 are not limited in this application. A person skilled in the art can define the positions of the sound absorbing portion 232 and the vibration attenuation portion 231 based on magnitudes of vibration generated by the vibration member 11 in different regions.

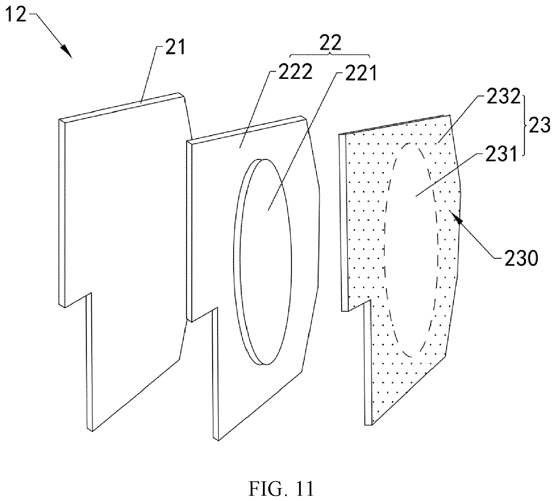

Refer to FIG. 11. FIG. 11 is a schematic diagram of a partially exploded structure of the housing 12 shown in FIG. 3 in a fifth implementation. In this implementation, the vibration assembly 10 includes most technical features of the foregoing implementation, and content of most technical solutions of this implementation that are the same as those in the foregoing implementation in the following is not described again. For example, the housing 12 includes an outer layer 21, an intermediate layer 22, and an inner layer 23. At least one of the intermediate layer 22 and the inner layer 23 includes a polymer material. The inner layer 23 includes a vibration attenuation portion 231 and a sound absorbing portion 232. The vibration attenuation portion 231 is in contact with the intermediate layer 22. The sound absorbing portion 232 and the intermediate layer 22 are disposed at an interval. The sound absorbing portion 232 is provided with a plurality of micro via holes 230 formed at intervals.

In this implementation, the intermediate layer 22 includes a protruding portion 221 and a flat portion 222. The protruding portion 221 protrudes from the flat portion 222. The protruding portion 221 is in contact with the vibration attenuation portion 231, and the flat portion 222 and the sound absorbing portion 232 are disposed at an interval. For example, the protruding portion 221 protrudes from the flat portion 222 towards one side close to the inner layer 23. In some embodiments, the flat portion 222 and the protruding portion 221 are integrally formed to save a process of preparing the intermediate layer 22.

It can be understood that an orthographic projection of the protruding portion 221 on the inner layer 23 and the sound absorbing portion 232 are staggered, that is, the projection of the protruding portion 221 on the inner layer 23 does not overlap the sound absorbing portion 232. In this case, a gap is formed between the sound absorbing portion 232 of the inner layer 23 and the intermediate layer 22, so that a cavity communicated with the micro via holes 230 is formed in the housing 12. As shown in FIG. 11, for example, a shape of the protruding portion 221 is the same as that of the vibration attenuation portion 231.

In this embodiment, the protruding portion 221 protruding towards the inner layer 23 is arranged in the intermediate layer 22, so that the cavity communicated with the micro via holes 230 is formed between the intermediate layer 22 and the inner layer 23. The plurality of micro via holes 230 of the sound absorbing portion 232 have a ventilation property. In this case, a micro-perforated plate sound absorbing structure is formed for the housing 12, and the sound waves (noise) generated by the vibration member 11 enter the cavity between the intermediate layer 22 and the sound absorbing portion 232 from the micro via holes 230. Air in the cavity generates intense vibration and friction. In this way, the sound energy is converted into heat energy, and the heat energy is dissipated, thereby further improving the noise reduction effect of the vibration assembly 10.

It can be understood that in the second implementation to the fourth implementation of the housing 12, the entire intermediate layer 22 is staggered with the sound absorbing portion 232, and the intermediate layer 22 is in contact with the vibration attenuation portion 231, so that the cavity is formed between the outer layer 21 and the sound absorbing portion 232. In the fifth implementation, the protruding portion 221 of the housing 12 is provided on the intermediate layer 22, and the protruding portion 221 is in contact the vibration attenuation portion 231, so that the cavity is formed between the flat portion 222 of the intermediate layer 22 and the sound absorbing portion 232 of the inner layer 23. In other implementations, the vibration attenuation portion 231 of the inner layer 23 is provided with a bulge towards one side of the intermediate layer 22, and the sound absorbing portion 232 and the intermediate layer 22 are disposed at an interval, so that the flat portion 222 of the intermediate layer 22 and the sound absorbing portion 232 form a cavity.

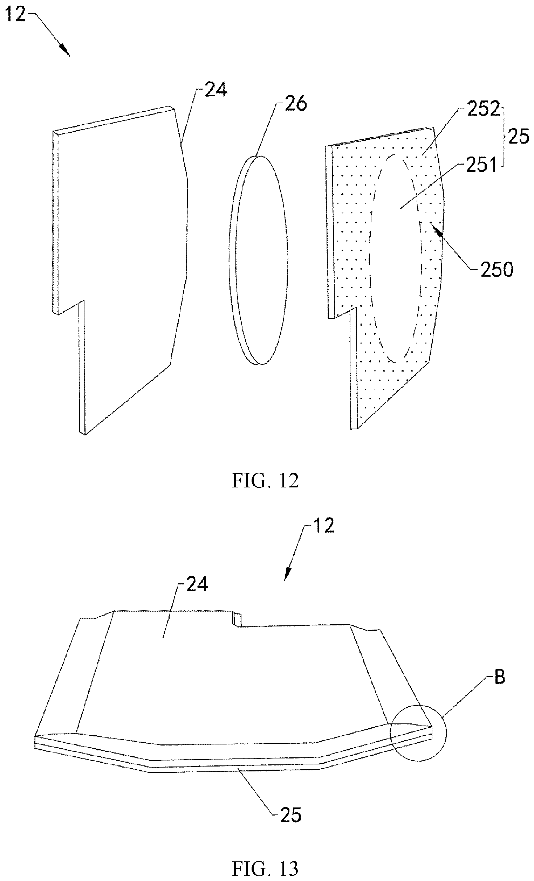

Refer to FIG. 12. FIG. 12 is a schematic diagram of a partially exploded structure of the housing 12 shown in FIG. 2 in Embodiment 2. In this embodiment, the vibration assembly 10 includes part of the technical features of the foregoing embodiment, and content of most technical solutions of this embodiment that are the same as those in the foregoing embodiment in the following is not described again. The housing 12 is mounted on an outer side of the vibration assembly. For example, the vibration assembly is a powertrain, a charging apparatus, a power distribution box, a self-driving hardware platform, a battery management system, or an intelligent cockpit.

In Embodiment 2 of the housing provided in this application, the housing 12 includes a plastic layer 26 and a shield layer 27. A material used for the plastic layer 26 includes a plastic material, and a material used for the shield layer 27 includes a metal material. The plastic material includes but is not limited to general engineering plastic and special engineering plastic. For example, the polymer material may alternatively be plastic such as polycarbonate (polycarbonate, PC), polyphenylene sulfide (phenylenesulfide, PPS), ABS plastic (acrylonitrile butadiene styrene plastic, ABS), or polyamide 66 (polyamide 66). The plastic layer 26 may include some additives, such as a glass fiber, a carbon fiber, or an asbestos fiber. A damping coefficient of the plastic layer 26 is greater than or equal to 0.05.

In this embodiment of this application, the housing 12 includes the plastic layer 26 that can convert mechanical vibration energy generated by the vibration member into heat energy for dissipation, thereby reducing vibration transferred by the vibration assembly to the outside, and helping reduce noise generated by the vibration assembly. In addition, costs of using the plastic material for the plastic layer 26 are relatively low. This can effectively reduce costs of the housing 12 and facilitate large-scale production of the housing 12. The housing includes the shield layer 27 to improve an electromagnetic shield capability of the vibration assembly.

A stacking order of the shield layer 27 and the plastic layer 26 is not limited in this application. In some implementations, the plastic layer 26 is located on an inner side of the housing 12, that is, the plastic layer 26 is located on one side of the shield layer 27 close to the vibration member. In some other implementations, the plastic layer 26 is located on an outer side of the housing 12, that is, the plastic layer 26 is located on one side of the shield layer 27 away from the vibration member. In this embodiment of this application, an example in which the plastic layer 26 is located on the outer side of the housing 12 is used for description.

In some other embodiments, when the plastic layer 26 uses conductive plastic, the housing 12 may not include the shield layer 27, that is, the housing 12 includes only the plastic layer 26 using the conductive plastic. The conductive plastic is a functional high polymer material obtained by mixing resin with a conductive substance and processing the mixture in a processing manner for plastic. In this embodiment, when the plastic layer 26 uses the conductive plastic, the housing 12 can also have an electromagnetic shield capability. In this case, no additional shield layer needs to be arranged in the housing 12, thereby simplifying a molding process of the housing 12 and facilitating assembling of the housing 12.

As shown in FIG. 12, in some embodiments, the shield layer 27 is located on an inner side of the housing 12. That is, the shield layer 27 is located on one of the plastic layer 26 close to the vibration member. The shield layer 27 is provided with a plurality of through holes 270 formed at intervals, and an aperture of each through hole 270 is less than or equal to 1 mm. In other embodiments, when the shield layer 27 is located on one side of the plastic layer 26 away from the vibration member 11, the plastic layer 26 is provided with a plurality of through holes 270 formed at intervals. That is, the through holes 270 are formed on one side of the housing 12 closest to the vibration member 11.

In this embodiment of this application, the shield layer 27 is provided with the plurality of small through holes 270 that are formed at intervals. Many run-through small gaps are formed in the shield layer 27. Sound waves (noise) generated by the vibration member 11 change with expansion and retraction of air when entering the small through holes 270, and vibrate on hole walls of the through holes 270 to generate friction. Due to effects of viscous damping and friction for heat generation of the shield layer 27 itself, sound energy is continuously converted into heat energy and dissipated, thereby reducing the noise generated by the vibration member 11 and helping reduce the noise of the vibration assembly 10.

In other embodiments, a sound absorbing cavity is formed between the plastic layer 26 and the shield layer 27, and the sound absorbing cavity is communicated with the through hole 270. For structures of a sound insulation layer 28 and the shield layer 27, refer to the structures of the intermediate layer 22 and the inner layer 23 in FIG. 11. Details are not described herein again.

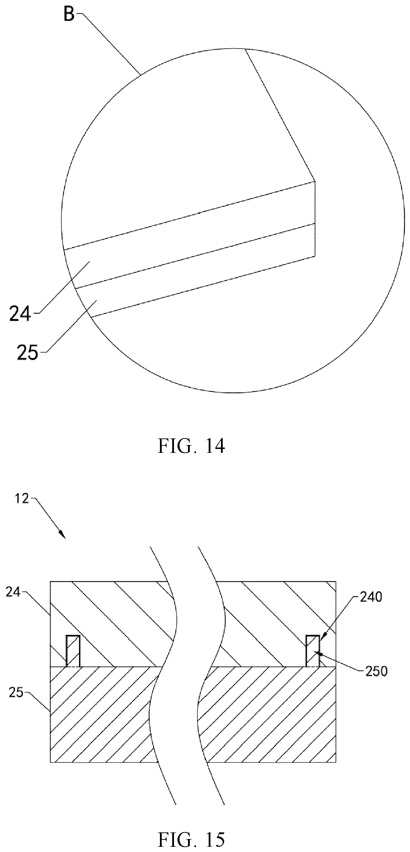

Refer to FIG. 13 and FIG. 14. FIG. 13 is a schematic diagram of a partial structure of a housing 12 shown in FIG. 2 in Embodiment 3; and FIG. 14 is a schematic diagram of an enlarged structure of portion B shown in FIG. 13. In this embodiment, the vibration assembly 10 includes most of the technical features of the foregoing embodiment, and content of most technical solutions of this embodiment that are the same as those in the foregoing embodiment in the following is not described again. For example, the vibration assembly 10 includes a vibration member 11 and a housing 12. The housing 12 is located at a circumferential edge of the vibration member 11. For example, the vibration assembly 10 is a powertrain, a charging apparatus, a power distribution box, a self-driving hardware platform, a battery management system, or an intelligent cockpit.

As shown in FIG. 14, in Embodiment 3, the housing 12 includes a polymer layer 24 and a metal layer 25. A material used for the polymer layer 24 includes a polymer material, and a material used for the metal layer 25 includes a metal material. In this application, a damping coefficient of the polymer layer 24 is greater than that of the metal layer 25. For example, the damping coefficient of the polymer layer 24 may be greater than or equal to 0.05. A damping coefficient is a standard for measuring a damping magnitude of a polymer material. A larger damping coefficient indicates better damping performance of the polymer material and a higher ability to dissipate vibration energy. Due to its characteristics, the polymer material is usually a viscoelastic material, such as rubber, asphalt, or a plastic material. The plastic material may be but is not limited to plastic such as polycarbonate (polycarbonate, PC), polyphenylene sulfide (phenylenesulfide, PPS), ABS plastic (acrylonitrile butadiene styrene plastic, ABS), polyamide 46 (polyamide 46, PA46), or polyamide 66 (polyamide 66, PA66). The ABS plastic is a ternary copolymer of three monomers: acrylonitrile (A), butadiene (B), and styrene (S). Relative contents of the three monomers can change flexibly to make various resins. The polyamide 66 is formed by condensing hexanedioic acid and hexadiamine. The polycarbonate (polycarbonate, PC) is a colorless and transparent non-qualitative thermoplastic material. When the material used for the polymer layer 24 includes plastic, the polymer 24 layer may include some additives, for example, a glass fiber, a carbon fiber, or an asbestos fiber.

In this embodiment of this application, the housing 12 includes the polymer layer 24 and the metal layer 25. The polymer layer 24 can effectively convert mechanical vibration energy generated by the vibration member 11 into heat energy for dissipation to reduce noise generated by the vibration assembly 10. The metal layer 25 can shield an electromagnetic signal to improve an electromagnetic shield capability of the vibration assembly 10. When the polymer layer 24 uses the plastic material, because costs of plastic are relatively low, costs of the housing 12 can be effectively reduced, thereby facilitating large-scale production of the housing 12. A person skilled in the art may select a proper polymer material based on a requirement of an actual product.

In some embodiments, the metal layer 25 is located at an innermost layer of the housing 12, and the polymer layer 24 is located on one side of the metal layer 25 away from the vibration member. For example, when the housing 12 includes a two-layer structure including a polymer layer 24 and a metal layer 25, the polymer layer 24 is an appearance side of the housing 12.

In this embodiment, the metal layer 25 is located on an inner side of the housing 12. The metal layer 25 located on the inner side of the housing 12 can be in direct contact with a bottom housing of the vibration member 11, thereby achieving a grounding purpose and simplifying an electromagnetic shield design of the housing 12. It can be understood that when a non-inner-layer structure (the outer layer or the intermediate layer) in the housing 12 uses the metal material, an edge structure of the housing 12 needs to be improved to make the metal shield layer in electrical contact with the bottom housing of the vibration member 11, to achieve the grounding purpose. In this case, the electromagnetic shield design of the housing 12 is relatively complex.

As shown in FIG. 14, in this embodiment of this application, an example in which the metal layer 25 is located on the inner side of the housing 12 is used for description. A stacking order of the polymer layer 24 and the metal layer 25 is not limited in this application. In some other embodiments, the metal layer 25 may alternatively be located on an outer side of the housing 12, that is, the metal layer 25 is located on one side of the polymer layer 24 away from the vibration member 11.

In some embodiments, a thickness of the polymer layer 24 is greater than or equal to that of the metal layer 25. In some embodiments, a thickness of the polymer layer 24 is greater than or equal to 1 mm. The thickness of the metal layer 25 is less than or equal to 1 mm. For example, the thickness of the polymer layer 24 is 2 mm, and the thickness of the metal layer 25 is 1 mm.

In this embodiment of this application, the thickness of the polymer layer 24 is greater than that of the metal layer 25. The polymer layer 24 can alternatively be relatively thick on the basis of ensuring that the housing 12 is relatively thin. Therefore, mechanical vibration of the housing 12 can be effectively dissipated to reduce noise.

Refer to FIG. 15. FIG. 15 is a schematic diagram of a partial cross section of the housing 12 shown in FIG. 13 in a first implementation. In some embodiments, the metal layer 25 and the polymer layer 24 are connected through fastening. For example, the metal layer 25 is provided with a bulge 240 protruding towards the polymer layer 24. The polymer layer 24 is provided with a groove 250 adapted to the bulge 240. The bulge 240 is fastened with the groove 250. In FIG. 15, shapes and sizes of the bulge 240 and the groove 250 are merely examples. They are not limited in this application. In other embodiments, a groove may also be formed in the metal layer 25, and a bulge adapted to the groove is formed in the polymer layer 24. A specific structure of fastening between the metal layer 25 and the polymer layer 24 is not limited in this application.

The bulge 240 is fastened to the groove 250, and the metal layer 25 abuts against a flange surface of the polymer layer 24. For example, the metal layer is integrally formed into a bulge 240 in a stamping manner When a material used for the polymer layer 24 includes a plastic material, the groove 250 is nested with a metal ring through injection molding to improve strength of the groove 250.

In this embodiment of this application, the metal layer 25 is positioned and fixedly connected to the polymer layer 24 through fastening to facilitate assembling of the metal layer 25 and the polymer layer 24. In other embodiments, the metal layer 25 and the polymer layer 24 may alternatively be connected by using glue or by riveting protruding points. This is not limited in this application.

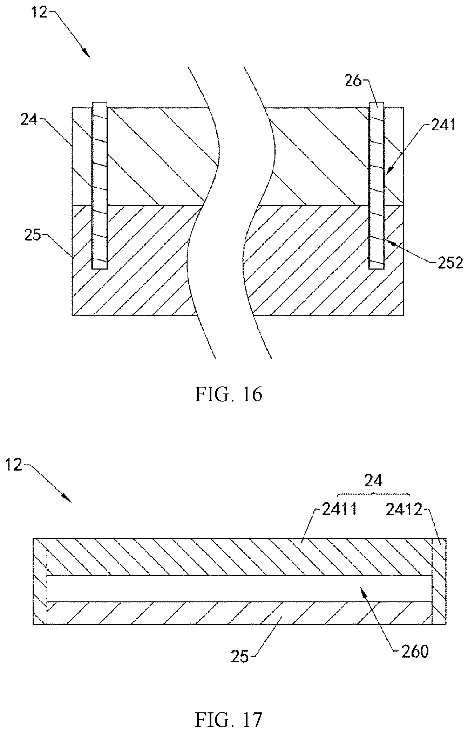

Refer to FIG. 16. FIG. 16 is a schematic diagram of a partial cross section of the housing 12 shown in FIG. 13 in a second implementation. In some embodiments, the housing 12 further includes a fastener 26. A first fastening hole 241 is formed on an edge of the polymer layer 24, and a second fastening hole 252 is formed on an edge of the metal layer 25. The fastener 26 passes through the first fastening hole 241 and the second fastening hole 252 to fasten the polymer layer 24 and the metal layer 25.

In this embodiment of this application, the polymer layer 24 and the metal layer 25 are fixedly connected by using the fastener 26 to improve firmness of the connection between the polymer layer 24 and the metal layer 25. Optionally, a metal sheet is embedded in the first fastening hole 241 of the polymer layer 24 to avoid a risk that the fastener 26 is not securely fastened when passing through the second fastening hole 252 of the metal layer 25, thereby further improving firmness of the housing 12. Edge wrapping processing may be or may not be performed on the edge of the housing 12. This is not limited in this application.

In some other embodiments, the polymer layer 24 and the metal layer 25 can also be integrally formed to simplify a molding process of the housing 12. For example, the polymer layer 24 and the metal layer 25 are integrally formed by using an intra-film injection molding process, and the polymer layer 24 and the metal layer 25 are directly molded by using a mold. Optionally, the metal layer 25 is provided with a bulge 240, and the polymer layer 24 is invertedly buckled with the bulge 240 after being melted, to increase a fastening force between the polymer layer 24 and the metal layer 25. Optionally, the metal layer 25 may be provided with a hole. This is not limited in this application. For example, the metal layer 25 may alternatively be a metal mesh, so that a weight of the housing 12 is reduced while electromagnetic compatibility protection of the vibration assembly 10 is improved. In some other embodiments, the metal layer 25 may be formed on the polymer layer 24 by using an electroplating process. It can be understood that a specific process of forming the metal layer 25 and the polymer layer 24 is not limited in this application, and a person skilled in the art can design them based on actual requirements.

Refer to FIG. 17. FIG. 17 is a schematic diagram of a cross section of the housing 12 shown in FIG. 13 in a third implementation. In some embodiments, a cavity 260 exists between the polymer layer 24 and the metal layer 25. That is, an air layer structure is formed between the metal layer 25 and the polymer layer 24.

In this embodiment of this application, the cavity 260 is formed between the polymer layer 24 and the metal layer 25. In this way, a direct contact area between the polymer layer 24 and the metal layer 25 is reduced, and vibration transferring is reduced. In addition, the cavity 260 effectively absorbs low-frequency noise generated by the vibration member, thereby further reducing noise generated by the vibration assembly.

For example, the polymer layer 24 includes a first main body portion 2411 and a first edge portion 2412 disposed around a circumferential edge of the first main body portion 2411. The first main body portion 2411 and the metal layer 25 are disposed at an interval. The first edge portion 2412 is fixedly connected to the metal layer 25, so that the cavity 260 is formed between the metal layer 25 and the polymer layer 24.

In some embodiments, the vibration member is provided with a first vibration region and a second vibration region. When the vibration assembly is in a working state, vibration of the first vibration region is greater than vibration of the second vibration region. For related descriptions of the vibration member, the first vibration region, and the second vibration region, refer to Embodiment 1. Details are not described herein again in this application. An orthographic projection of the first main body portion 2411 on the vibration member covers at least the first vibration region. That is, the orthographic projection of the first main body portion 2411 on the vibration member covers the region of the vibration member that has relatively large noise. In this embodiment of this application, an example in which the orthographic projection of the first main body portion 2411 on the vibration member covers the entire first vibration region and part of the second vibration region is used for description. In other embodiments, the orthographic projection of the first main body portion 2411 on the vibration member may alternatively cover only the first vibration region. This is not limited in this application.

In this embodiment of this application, the orthographic projection of the first main body portion 2411 on the vibration member covers the first vibration region, that is, an orthographic projection of the cavity 260 formed by the polymer layer 24 and the metal layer 25 on the vibration member covers the first vibration region. The cavity 260 can effectively dissipate noise generated by the vibration member, thereby effectively reducing noise generated by the vibration assembly.

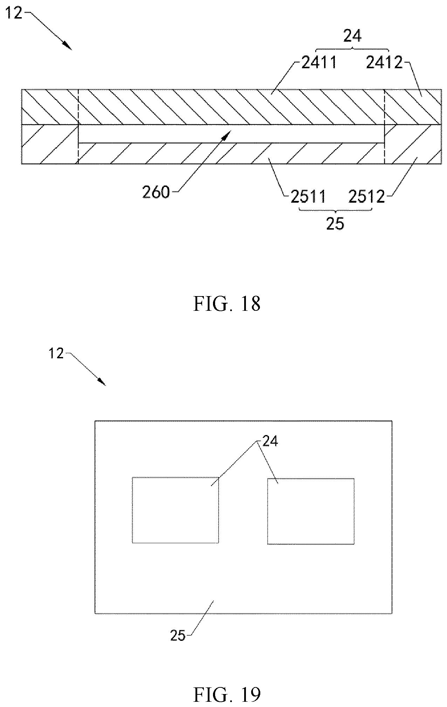

Refer to FIG. 18. FIG. 18 is a schematic diagram of a cross section of the housing 12 shown in FIG. 13 in a fourth implementation. In some embodiments, the metal layer 25 includes a second main body portion 2511 and a second edge portion 2512 arranged around a circumferential edge of the second main body portion 2511. The second main body portion 2511 is recessed relative to the second edge portion 2512 towards one side away from the first main body portion 2411. The second edge portion 2512 is fixedly connected to the polymer layer 24.

In this embodiment of this application, the second main body portion 2511 of the metal layer 25 is recessed relative to the second edge portion 2512, that is, an intermediate portion of the metal layer 25 is recessed inwards. The polymer layer 24 is fixedly connected to an edge of the metal layer 25, so that the cavity 260 is formed between the metal layer 25 and the polymer layer 24. In other embodiments, the polymer layer 24 can also protrude relative to the metal layer 25, so that the cavity 260 is formed between the polymer layer 24 and the metal layer 25.

In some embodiments, a thickness of the first edge portion 2412 in the polymer layer 24 is increased, or a thickness of the second edge portion 2512 in the metal layer 25 is increased to improve sealing between the polymer layer 24 and the metal layer 25, and prevent noise from leaking from the cavity 260 out of the vibration assembly, thereby further improving the noise reduction performance of the housing 12. In some other embodiments, the housing 12 can also improve the sealing performance between the polymer layer 24 and the metal layer 25 by increasing a quantity of fasteners and reducing a distance between the fasteners.

In the first implementation to the fourth implementation of the housing, the housing 12 includes at least the polymer layer 24 and the metal layer 25. The housing 12 may alternatively include other layer structures. This is not limited in this application. A quantity of polymer layers 24 and a quantity of metal layers 25 are not limited in this application. That is, the housing 12 may be of a two-layer structure or a multi-layer structure. For example, in some embodiments, metal layers 25 can be arranged on both sides of the polymer layer 24 that are disposed back to each other. In this case, the housing 12 includes a first metal layer 25, a polymer layer 2425, and a second metal layer 25 that are sequentially disposed. In some other embodiments, when the polymer layer 24 uses a plastic material, plastic layers can also be arranged on both sides of the metal layer 25 that are disposed back to each other. In this case, the housing 12 includes a first plastic layer (polymer layer 24), a metal layer 25, and a second plastic layer (polymer layer 24) that are disposed in sequence.

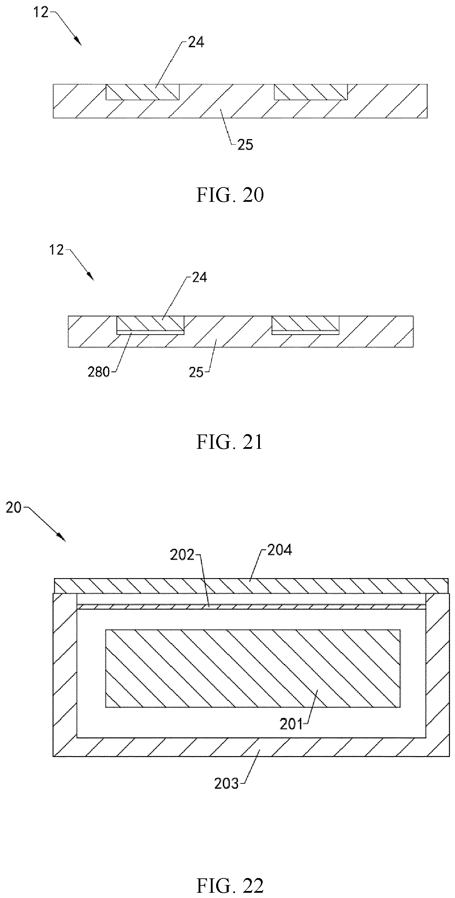

Refer to FIG. 19. FIG. 19 is a top view of the housing 12 shown in FIG. 13 in a fifth implementation, and FIG. 20 is a schematic diagram of a cross section of the housing 12 shown in FIG. 19. In this implementation, the vibration assembly 10 includes most technical features of the foregoing implementation, and content of most technical solutions of this implementation that are the same as those in the foregoing implementation in the following is not described again.

In this implementation, the housing 12 includes a metal layer 25 and a polymer layer 24 embedded in the metal layer 25. For example, the metal layer 25 is provided with one or more grooves 255. The polymer layer 24 is accommodated in the grooves 255. A material used for the metal layer 25 includes a metal material. A material used for the polymer layer 24 includes a polymer material. For example, a quantity of grooves 255 in FIG. 20 is merely an example. This is not limited in this application. In other embodiments, there may be only one groove 255 in the metal layer 25.

In this embodiment of this application, the polymer layer 24 in the housing 12 is embedded in the metal layer 25, and the polymer layer 24 can effectively dissipate mechanical vibration generated by the vibration member, thereby reducing noise. In addition, the polymer layer 24 is embedded in the metal layer 25, so that a thickness of the housing 12 is effectively reduced on the basis of ensuring that the housing 12 has vibration attenuation, noise reduction, and signal shield functions.

In some embodiments, the vibration member is provided with a first vibration region and a second vibration region. When the vibration assembly is in a working state, vibration of the first vibration region is greater than vibration of the second vibration region. For related descriptions of the vibration member, the first vibration region, and the second vibration region, refer to Embodiment 1. Details are not described herein again in this application. An orthographic projection of the polymer layer 24 on the vibration member covers at least the first vibration region. That is, the orthographic projection, on the vibration member, of the polymer layer 24 embedded in the metal layer 25 covers at least a region of the vibration member that has relatively large noise.

In this embodiment of this application, the orthographic projection, on the vibration member, of the polymer layer 24 embedded in the metal layer 25 covers the first vibration region, and the polymer layer 24 can effectively dissipate noise generated by the vibration member, thereby effectively reducing noise generated by the vibration assembly.

In some embodiments, the polymer layer 24 and the metal layer 25 are integrally formed. For example, the polymer layer 24 and the metal layer 25 are integrally formed by using an intra-film injection molding process, and the polymer layer 24 and the metal layer 25 are directly molded by using a mold to simplify a molding process of the housing 12.

Refer to FIG. 21. FIG. 21 is a schematic diagram of a cross section of the housing 12 shown in FIG. 13 in a sixth implementation. Most content of the housing 12 in the sixth implementation is the same as that in the fifth implementation. Details are not described herein again in this application. The following mainly describes a difference between this implementation and the fifth implementation.

In the sixth implementation, an air layer is formed between the polymer layer 24 and the metal layer 25. That is, the polymer layer 24 and the metal layer 25 are disposed at an interval.

In this embodiment of this application, the air layer 280 is formed between the polymer layer 24 and the metal layer 25. In this way, a direct contact area between the polymer layer 24 and the metal layer 25 is reduced, and vibration transferring is reduced. In addition, the cavity 260 effectively absorbs low-frequency noise generated by the vibration member, thereby further reducing noise generated by the vibration assembly.

It should be noted that in all the schematic diagrams of the cross section of the housing 12 provided in this application, the example in which an outer surface of the housing 12 is roughly planar is used for description. In actual application, an overall structure of the housing 12 may alternatively be curved, that is, part of the structure of the housing 12 is arched relative to the internal vibration member. For example, when part of the structure of the vibration member in the vibration assembly 10 protrude from the bottom housing (the second housing 122 and the third housing 133 in FIG. 2), part of the structure of the housing 12 can be arched to adapt to different shapes of the vibration member, so as to cover the housing 12 and the bottom housing. A person skilled in the art can design an appearance shape of the housing 12 based on an actual requirement. This is not limited in this application.

Refer to FIG. 22. FIG. 22 is a schematic diagram of a partial cross section of the vibration assembly 20 shown in FIG. 1 in another embodiment. The vibration assembly 22 includes a vibration member 201, a shield member 202, a bottom housing 203, and a cover plate 204. The vibration member 201 vibrates to generate noise during operation. For example, the vibration assembly 20 is a powertrain, a charging apparatus, a power distribution box, a self-driving hardware platform, a battery management system, or an intelligent cockpit.

As shown in FIG. 20, the bottom housing 203 is provided with an accommodation space 200. Both the vibration member 201 and the shield member 202 are both accommodated in the accommodation space 200, and the shield member 202 is located above the vibration member 201. The cover plate 204 is located above the shield member 202, and covers the bottom housing 203. A material used for the shield member 202 includes a metal material. The shield member 202 is configured to avoid an electromagnetic signal generated by the vibration member 201 from interfering with an electronic element outside the vibration assembly 20, and to also avoid an electromagnetic signal generated by an electronic element outside the vibration assembly 20 from interfering with the vibration member 201 inside the vibration assembly 20.

A material used for the cover plate 204 includes a polymer material. The polymer material may be a viscoelastic material such as rubber or asphalt, or may be a plastic material. The plastic material may be but is not limited to plastic such as polycarbonate (polycarbonate, PC), polyphenylene sulfide (phenylenesulfide, PPS), ABS plastic (acrylonitrile butadiene styrene plastic, ABS), polyamide 46 (polyamide 46, PA46), or polyamide 66 (polyamide 66, PA66). The cover plate 204 may use one or more materials. This is not limited in this application.

In this embodiment of this application, the polymer material used in the cover plate 204 can effectively convert mechanical vibration energy generated by the vibration member 201 into heat energy for dissipation, thereby reducing vibration transferred by the vibration assembly 20 to the outside, helping reduce noise generated by the vibration assembly 20, and improving noise, vibration, and harshness performance of the vehicle.

In this embodiment, the shield member 202, configured to shield an electromagnetic signal, in the vibration assembly 20 is accommodated in the accommodation space 200 formed by the bottom housing 203. In this case, the cover plate 204 can be made of an all-polymer material and is relatively thick, to further improve vibration attenuation and noise reduction effects of the vibration assembly 20.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A housing, comprising a polymer layer and a metal layer, wherein the metal layer is located at an innermost layer of the housing, and a material used for the metal layer comprises a metal material; the polymer layer is located on an outer side of the metal layer, and a material used for the polymer layer comprises a polymer material; and a cavity exists between the polymer layer and the metal layer

2. The housing according to claim 1, wherein the polymer layer comprises a first main body portion and a first edge portion arranged around a circumferential edge of the first main body portion; the first main body portion and the metal layer are spaced apart from each other; and the first edge portion is fixedly connected to the metal layer, so that the cavity is formed between the metal layer and the polymer layer.

3. The housing according to claim 2, wherein the metal layer comprises a second main body portion and a second edge portion arranged around a circumferential edge of the second main body portion; the second main body portion is recessed relative to the second edge portion towards one side away from the first main body portion; and the second edge portion is fixedly connected to the polymer layer.

4. The housing according to claim 2, wherein the housing is applied to an enclosure of a vibration member in a vehicle; the vibration member is provided with a first vibration region and a second vibration region; when the vibration assembly is in a working state, vibration of the first vibration region is greater than vibration of the second vibration region; and an orthographic projection of the first main body portion on the vibration member covers at least the first vibration region.

5. The housing according to any one of claims 1 to 4, wherein the metal layer and the polymer layer are connected through mutual fastening.

6. The housing according to any one of claims 1 to 5, wherein the housing further comprises a fastener; a first fastening hole is formed on an edge of the polymer layer; a second fastening hole is formed on an edge of the metal layer; and the fastener passes through the first fastening hole and the second fastening hole to fasten the polymer layer and the metal layer.

7. The housing according to any one of claims 1 to 3, wherein the polymer layer and the metal layer are integrally formed.

8. A housing, comprising a metal layer and a polymer layer embedded in the metal layer, wherein the metal layer is provided with one or more grooves; the polymer layer is accommodated in the grooves; a material used for the metal layer comprises a metal material; and a material used for the polymer layer comprises a polymer material.

9. The housing according to claim 8, wherein an air layer is formed between the polymer layer and the metal layer.

10. The housing according to claim 8 or 9, wherein the housing is applied to an enclosure of a vibration member in a vehicle; the vibration member is provided with a first vibration region and a second vibration region; when the vibration assembly is in a working state, vibration of the first vibration region is greater than vibration of the second vibration region; and an orthographic projection of the polymer layer on the vibration member covers at least the first vibration region.

11. The housing according to claim 8 or 9, wherein the polymer layer and the metal layer are integrally formed.

12. A vibration assembly, comprising a vibration member and the housing according to any one of claims 1 to 11, wherein the housing is located on an outer side of the vibration member

13. The vibration assembly according to claim 12, wherein the vibration assembly is a powertrain, a charging apparatus, a power distribution box, a self-driving hardware platform, a battery management system, or an intelligent cockpit.

14. A housing, comprising an outer layer, an intermediate layer, and an inner layer, wherein the outer layer is located on an appearance side of the housing; the intermediate layer is located between the outer layer and the inner layer; at least one of the intermediate layer and the inner layer comprises a polymer material; and the inner layer is provided with a plurality of micro via holes formed at intervals.

15. The housing according to claim 14, wherein the inner layer comprises a sound absorbing portion and a vibration attenuation portion that is disposed in a staggered manner with the sound absorbing portion; the micro via holes are located in the sound absorbing portion; the sound absorbing portion and the intermediate layer are disposed at an interval; and the vibration attenuation portion is in contact with the intermediate layer.

16. The housing according to claim 15, wherein the intermediate layer is provided with a sound absorbing cavity running through the intermediate layer; the sound absorbing cavity is communicated with the micro via holes; and the sound absorbing cavity is formed corresponding to the sound absorbing portion.

17. The housing according to claim 15, wherein the intermediate layer comprises a flat portion and a protruding portion protruding on one side of the flat portion; the protruding portion is in contact with the vibration attenuation portion; and the flat portion and the sound absorbing portion are disposed at an interval.

18. The housing according to any one of claims 15 to 17, wherein a porosity rate of the micro via holes formed in the sound absorbing portion ranges from 0.5% to 5%.

19. The housing according to any one of claims 14 to 18, wherein materials used for the outer layer and the inner layer comprise metal materials, and the polymer material comprises rubber, asphalt, plastic, or the like.

20. A vibration assembly, comprising a vibration member and the housing according to any one of claims 14 to 19, wherein the housing is mounted on an outer side of the vibration member

21. The vibration assembly according to claim 20, wherein the vibration member is provided with a first vibration region and a second vibration region; when the vibration assembly is in a working state, vibration of the first vibration region is greater than vibration of the second vibration region; the micro via holes are formed corresponding to the second vibration region; and an orthographic projection of at least part of the intermediate layer on the vibration member is located in the first vibration region.

22. A vibration assembly, comprising a vibration member and a housing located on an outer side of the vibration member, wherein the housing comprises an outer layer, an intermediate layer, and an inner layer; the outer layer is located on an appearance side of the housing; the intermediate layer is located between the outer layer and the inner layer; and at least one of the intermediate layer and the inner layer comprises a polymer material, and the other one comprises a metal material.

23. The vibration assembly according to claim 22, wherein a material used for the intermediate layer comprises a polymer material, and materials used for the outer layer and the inner layer comprise metal materials; or
a material used for the intermediate layer comprises a metal material, and materials used for the outer layer and the inner layer comprise polymer materials.

24. A vibration assembly, comprising a vibration member, a shield member, a bottom housing, and a cover plate, wherein the bottom housing is provided with an accommodation space; both the vibration member and the shield member are accommodated in the accommodation space; the shield member is located above the vibration member; the cover plate is located above the shield member, and covers the bottom housing; a material used for the shield member comprises a metal material; and a material used for the cover comprises a polymer material.

25. A vehicle, comprising a vehicle body and the vibration assembly according to any one of claims 12, 13, and 20 to 24, wherein the vehicle body is mounted on the vibration assembly.
